# EUROPEAN PATENT APPLICATION

(11) **EP 4 336 553 A1**
(43) Date of publication of application: **13.03.2024**
(21) Application number: 23195836.4
(22) Date of filing: 06.09.2023
(51) Int. Cl.: H01L 23/522

(54) **INTEGRATED CIRCUIT DEVICES INCLUDING VIA CAPACITORS**

(30) Priority: 08.09.2022 KR 20220114461; 21.04.2023 KR 20230052826
(71) Applicant: Samsung Electronics Co., Ltd., Suwon-si, Gyeonggi-do 16677 (KR)
(72) Inventor: KIM, Jeewoong, 16677 Suwon-si (KR); KIM, Hojun, 16677 Suwon-si (KR); LEE, Sungmoon, 16677 Suwon-si (KR); CHA, Seungmin, 16677 Suwon-si (KR)
(74) Representative: Marks & Clerk LLP

(57) **Abstract**

An integrated circuit device comprising: a dielectric layer; a first power delivery network layer on a first surface of the dielectric layer; a second power delivery network layer on a second surface of the dielectric layer, wherein the second surface is opposite to the first surface in a vertical direction; and a via capacitor between the first surface and the second surface of the dielectric layer, wherein the via capacitor includes a first via electrode structure and a second via electrode structure that are spaced apart from each other in one of a first horizontal direction and a second horizontal direction that intersects with the first horizontal direction, and a first end portion and a second end portion that is opposite to the first end portion of the via capacitor are electrically connected to the first power delivery network layer and the second power delivery network layer, respectively.

## Description

### BACKGROUND

Integrated circuit devices may include capacitors as noise filters to improve operating speed by removing noises between operating power sources. Integrated circuit devices may include capacitors as signal delay means for matching signal times between transistors. As the integrated circuit devices become highly integrated, the integrated circuit devices may require that the capacitors be arranged in a smaller area in a plan view.

### SUMMARY

The inventive concept provides integrated circuit devices including via capacitors that are arranged in a small area in a plan view. According to an aspect of the inventive concept, there is provided an integrated circuit device comprising: a dielectric layer; a first power delivery network layer on a first surface of the dielectric layer; a second power delivery network layer on a second surface of the dielectric layer, wherein the second surface of the dielectric layer is opposite to the first surface of the dielectric layer in a vertical direction; and a via capacitor between the first surface and the second surface of the dielectric layer, wherein the via capacitor includes a first via electrode structure and a second via electrode structure that are spaced apart from each other in one of a first horizontal direction and a second horizontal direction that intersects with the first horizontal direction, and a first end portion and a second end portion that is opposite to the first end portion of the via capacitor are electrically connected to the first power delivery network layer and the second power delivery network layer, respectively.

According to another aspect of the inventive concept, there is provided an integrated circuit device comprising: a dielectric layer; a first power delivery network layer on a first surface of the dielectric layer; a second power delivery network layer on a second surface of the dielectric layer, wherein the second surface of the dielectric layer is opposite to the first surface of the dielectric layer in a vertical direction; and a plurality of via capacitors between the first surface and the second surface of the dielectric layer, wherein the plurality of via capacitors include a plurality of via electrode structures that are spaced apart from each other in one of a first horizontal direction and a second horizontal direction that intersects with the first horizontal direction, wherein first end portions of the plurality of via capacitors are electrically connected to the first power delivery network layer, and wherein second end portions opposite to the first end portions of the plurality of via capacitors in the vertical direction are electrically connected to the second power delivery network layer.

According to another aspect of the inventive concept, there is provided an integrated circuit device comprising: a dielectric layer; a first power delivery network layer on a first surface of the dielectric layer; a second power delivery network layer on a second surface of the dielectric layer, wherein the second surface of the dielectric layer is opposite to the first surface of the dielectric layer in a vertical direction; a plurality of via capacitors between the first surface and the second surface of the dielectric layer, wherein the plurality of via capacitors includes a plurality of via electrode structures that are spaced apart from each other in one of a first horizontal direction and a second horizontal direction that intersects with the first horizontal direction, and wherein first end portions and second end portions of the plurality of via capacitors are electrically connected to the first power delivery network layer and the second power delivery network layer, respectively; and a plurality of guard ring structures spaced apart from one of the first power delivery network layer and the second power delivery network layer, wherein the plurality of guard ring structures include additional via electrode structures between the first surface and second surface of the dielectric layer.

At least some of the above and other features of the invention are set out in the claims.

### BRIEF DESCRIPTION OF THE DRAWINGS

Embodiments of the inventive concept will be more clearly understood from the following detailed description taken in conjunction with the accompanying drawings in which:
FIG. 1A is a schematic partial layout of an integrated circuit device including a via capacitor, according to some embodiments of the inventive concept;
FIG. 1B is a schematic circuit diagram of the integrated circuit device shown in FIG. 1A;
FIGS. 2A and 2B and FIGS. 3A and 3B are cross-sectional views of an integrated circuit device including the via capacitor shown in FIGS. 1A and 1B, according to some embodiments of the inventive concept;
FIGS. 4A and 4B and FIGS. 5A and 5B are cross-sectional views illustrating an integrated circuit device including the via capacitor in FIGS. 1A and 1B, according to some embodiments of the inventive concept;
FIGS. 6A and 6B and FIGS. 7A and 7B are cross-sectional views illustrating an integrated circuit device including the via capacitor in FIGS. 1A and 1B, according to an embodiment;
FIGS. 8A and 8B and FIGS. 9A and 9B are cross-sectional views illustrating an integrated circuit device including the via capacitor in FIGS. 1A and 1B, according to some embodiments of the inventive concept;
FIG. 10A is a schematic partial layout of an integrated circuit device including a via capacitor according to some embodiments of the inventive concept;
FIG. 10B is a schematic circuit diagram of the integrated circuit device shown in FIG. 10;
FIGS. 11A and 11B and FIGS. 12A and 12B are cross-sectional views of an integrated circuit device including the via capacitor shown in FIGS. 10A and 10B, according to some embodiments of the inventive concept;
FIG. 13A is a schematic partial layout of an integrated circuit device including a via capacitor according to some embodiments of the inventive concept;
FIG. 13B is a schematic circuit diagram of the integrated circuit device shown in FIG. 13A;
FIGS. 14A and 14B and FIGS. 15A and 15B are cross-sectional views of an integrated circuit device including the via capacitor shown in FIGS. 13A and 13B, according to some embodiments of the inventive concept;
FIG. 16 is a layout of an integrated circuit device including a via capacitor according to some embodiments of the inventive concept;
FIG. 17 is a layout of an integrated circuit device including a via capacitor according to some embodiments of the inventive concept;
FIG. 18 is a schematic circuit diagram of an integrated circuit device according to some embodiments of the inventive concept;
FIG. 19A is a layout of an integrated circuit device including a via capacitor according to some embodiments of the inventive concept;
FIG. 19B is a schematic circuit diagram of the integrated circuit device in FIG. 19A;
FIG. 20 is a schematic circuit diagram of an integrated circuit device according to some embodiments of the inventive concept;
FIG. 21 is a layout of an integrated circuit device including a via capacitor according to some embodiments of the inventive concept;
FIG. 22 is a layout of an integrated circuit device including a via capacitor according to some embodiments of the inventive concept;
FIG. 23 is a layout of an integrated circuit device including a via capacitor according to some embodiments of the inventive concept;
FIG. 24A is a schematic circuit diagram of an integrated circuit device according to some embodiments of the inventive concept;
FIGS. 24B and 24C are layouts of an integrated circuit device including a via capacitor according to some embodiments of the inventive concept;
FIG. 25 is a schematic circuit diagram of an integrated circuit device according to some embodiments of the inventive concept;
FIG. 26 is a schematic circuit diagram of an integrated circuit device according to some embodiments of the inventive concept;
FIG. 27 is a cross-sectional view of an integrated circuit device according to some embodiments of the inventive concept; and
FIG. 28 is a block diagram showing a configuration of an electronic device including an integrated circuit device according to some embodiments of the inventive concept.

### DETAILED DESCRIPTION

Hereinafter, embodiments of the technical idea of the inventive concept are described in detail with reference to the accompanying drawings. The following embodiments of the inventive concept may be implemented individually or in combinations thereof. Therefore, the technical idea of the inventive concept is not limited to a single embodiment.

Herein, the singular forms of the elements may include a plurality of forms, unless the context clearly dictates otherwise. Herein, the drawings may be exaggerated to explain the inventive concept more clearly. In the following drawings, the same or similar reference numbers may denote the same or similar elements.

According to the technical idea of the inventive concept, a capacitor, such as a via capacitor, may be implemented by using a front wiring layer, a back (rear) wiring layer, and a structure therebetween. In the technical idea of the inventive concept, the front wiring layer and the back (rear) wiring layer for implementing a capacitor such as the via capacitor may include a single metal wiring layer or a plurality of metal wiring layers. In addition, in the technical idea of the inventive concept, at least one of the front wiring layer and the back (rear) wiring layer may include a power delivery network layer. "At least one of A and B" may mean "A", "B", or "A and B". "At least one of A and B" need not be interpreted as "at least one of A" and "at least one of B".

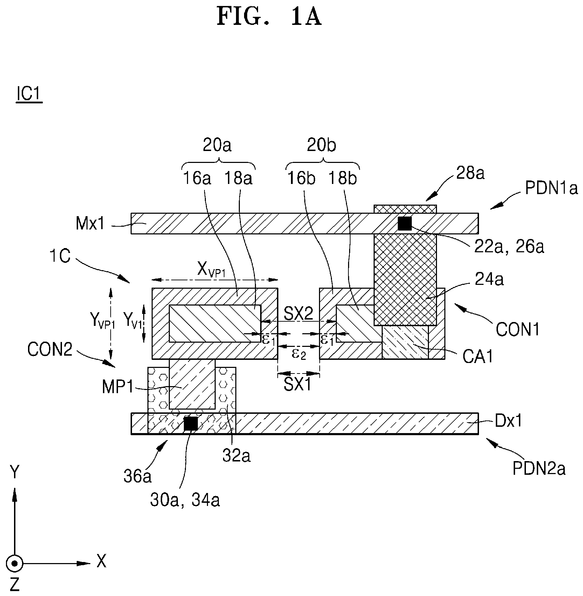

FIG. 1A is a schematic partial layout of an integrated circuit device including a via capacitor, according to some embodiments of the inventive concept.

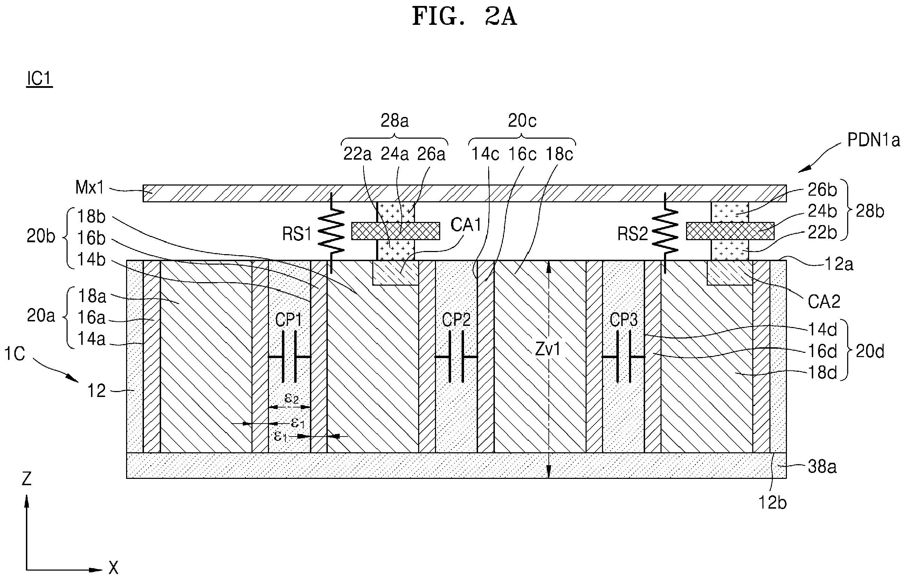

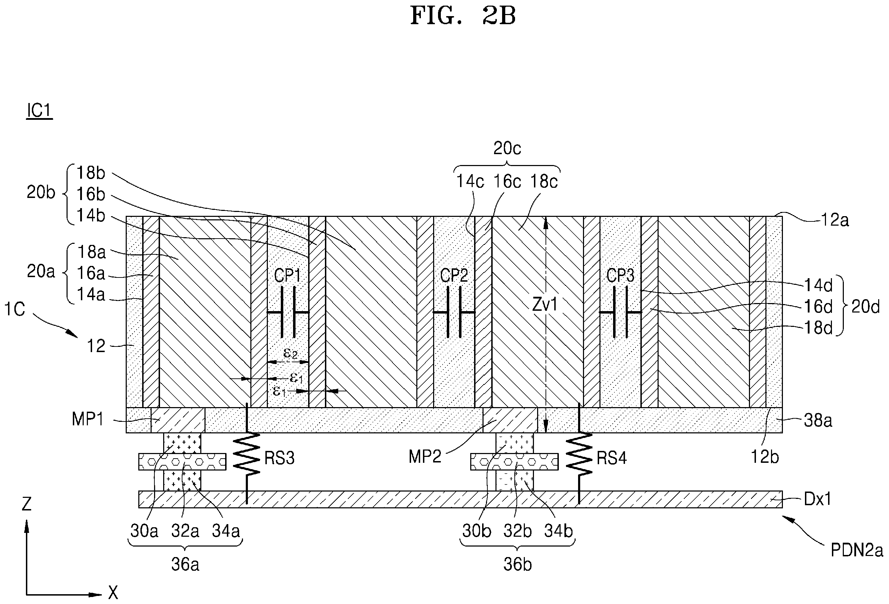

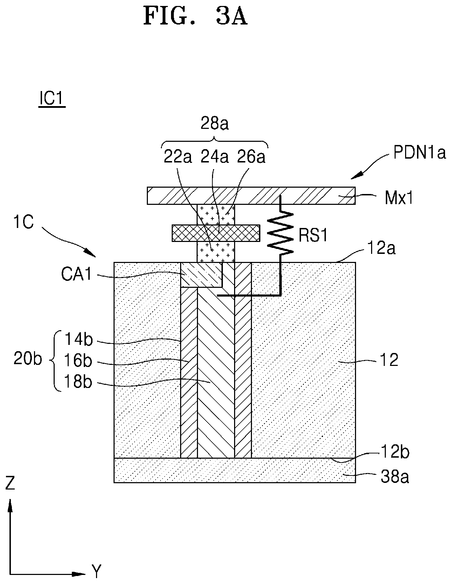

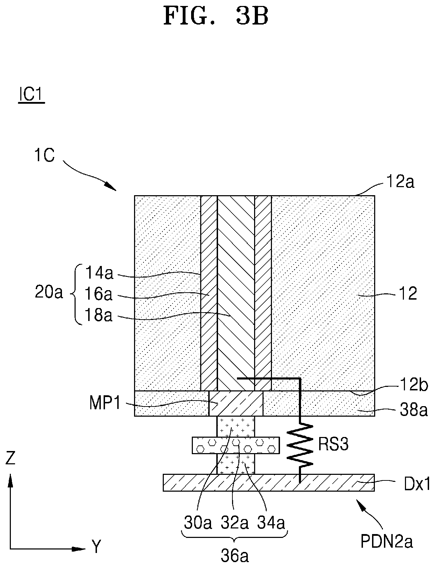

Specifically, referring to FIG. 1A, an integrated circuit device IC1 may include a dielectric layer 12 (shown in FIGS. 2A, 2B, 3A, and 3B), a via capacitor 1C, a first power delivery network layer PDN1a, and a second power delivery network layer PDN2a.

The integrated circuit device IC1 may include the via capacitor 1C. The via capacitor 1C may be implemented by using the first power delivery network layer PDN1a and the second power delivery network layer PDN2a in the integrated circuit device IC1. The via capacitor 1C may be arranged in at least one of a cell region and a peripheral circuit region of the integrated circuit device IC1.

A transistor (not shown) may be formed at a level of the dielectric layer 12 in FIGS. 2A, 2B, 3A, and 3B. For example, the transistor may be arranged at a position spaced apart from the via capacitor 1C in a first direction (X direction) or a second direction (Y direction), and at least one of the source/drain, the gate, and the channel of the transistor may overlap the dielectric layer 12 in FIGS. 2A, 2B, 3A, and 3B in the first direction (first horizontal direction / X direction) or the second direction (second horizontal direction / Y direction). The first direction and the second direction may be parallel with a first surface 12a and/or a second surface 12b of the dielectric layer 12. The first direction and the second direction may be considered horizontal directions. A horizontal direction may be any direction that runs parallel to the first surface 12a and/or the second surface 12b. Each of the first and second directions may be perpendicular to a third direction (vertical direction / Z direction). The third direction may be perpendicular to the first surface 12a and/or the second surface 12b of the dielectric layer 12. The third direction may be a vertical direction. The first and second directions may intersect with one another. In some embodiments, the first to third directions may be perpendicular to each other. For example, overlapping element A with element B in a horizontal direction (e.g., the first direction or the second direction) herein may mean that element A has at least a portion at the same vertical distance (e.g., in the third direction) as at least a portion of element B from the first surface 12a or the second surface 12b of the dielectric layer 12.

The via capacitor 1C may include a first via electrode structure 20a and a second via electrode structure 20b spaced apart from each other in the first direction (X direction). The first via electrode structure 20a and the second via electrode structure 20b may be arranged to face each other in the first direction (X direction). In some embodiments, the via capacitor 1C may be a penetrating via capacitor (e.g. a through-chip via capacitor) or a penetrating silicon via capacitor (e.g. a through-silicon via capacitor). In some embodiments, the via capacitor 1C may be a vertical via capacitor or a vertical-type via capacitor.

The first via electrode structure 20a may include a first via electrode 18a and a first via insulating layer 16a extending around (e.g., surrounding) the first via electrode 18a in a plan view. For example, the first via insulating layer 16a may be on opposing (e.g., both) sidewalls of the first via electrode 18a in a cross-sectional view. The second via electrode structure 20b may include a second via electrode 18b and a second via insulating layer 16b extending around (e.g., surrounding) the second via electrode 18b in a plan view. For example, the second via insulating layer 16b may be on opposing (e.g., both) sidewalls of the second via electrode 18b in a cross-sectional view. In a plan view, a capacitor component may be formed between the first via electrode structure 20a and the second via electrode structure 20b. As described herein, "in plan view" may mean when viewed along the third direction.

In some embodiments, as shown in FIG. 1A, the first via electrode structure 20a and the second via electrode structure 20b may be sequentially arranged in the first direction (X direction). In some embodiments, unlike FIG. 1A, the first via electrode structure 20a and the second via electrode structure 20b may be sequentially arranged in the second direction (Y direction). In other words, the first via electrode structure 20a and the second via electrode structure 20b may be sequentially arranged in the first direction (X direction) or the second direction (Y direction).

The first via electrode 18a and the second via electrode 18b may include a metal layer. For example, the metal layer may include copper, aluminum, or tungsten, but embodiments are not limited thereto. The first via insulating layer 16a and the second via insulating layer 16b may include a silicon oxide layer, a silicon nitride layer, a silicon carbide layer, a silicon oxycarbide layer, a silicon oxynitride layer, and/or a silicon oxycarbonitride layer, but are not limited thereto.

The first power delivery network layer PDN1a may include a first active connection line 28a electrically connected to the second via electrode structure 20b through a first active contact CA1 and a first active wiring line Mx1 electrically connected to the first active connection line 28a. The first power delivery network layer PDN1a may include a front side power delivery network layer FSPDN that is arranged on a front side of the dielectric layer 12 in FIGS. 2A, 2B, 3A, and 3B, as described below. The front side of the dielectric layer may refer to the first sided 12a of the dielectric layer 12. The electrical connection of the first active contact CA1 with the first active wiring line Mx1 through the first active connection line 28a is referred to as active connection relationship CON1.

The first active wiring line Mx1 may extend in the first direction (X direction). The first active contact CA1 may be formed by the same process for forming the source/drain contact in the active region. The active region may be a region that is formed of the source/drain, the gate, and the channel of the transistor. The inactive region may be a region that is not formed of the source/drain, the gate, and the channel of the transistor. For example, the first active contact CA1 may be formed together with the source/drain contact in the active region. The first active contact CA1 may include the same material as the source/drain contact in the active region. In addition, the first active contact CA1 may be positioned at the same height as the source/drain contact in the active region in the Z direction.

The first active connection line 28a may include a first active connection wiring layer 24a extending in the second direction (Y direction) and first active connection via layers 22a and 26a electrically connecting the first active connection wiring layer 24a with the first active wiring line Mx1.

The second power delivery network layer PDN2a may include a first pad connection line 36a electrically connected to the first via electrode structure 20a through a first conductive pad MP1 and a first pad wiring line Dx1 electrically connected to the first pad connection line 36a.

The second power delivery network layer PDN2a may include a back side power delivery network layer BSPDN that is provided on a back side (or a lower surface) of the dielectric layer 12 in FIGS. 2A, 2B, 3A, and 3B, as described below. The back side of the dielectric layer 12 may refer to an opposite side of the front side of the dielectric layer. In some embodiments, the back side of the dielectric layer 12 may refer to the second surface 12b of the dielectric layer 12. The electrical connection of the first conductive pad MP1 with the first pad wiring line Dx1 through the first pad connection line 36a is referred to as pad connection relationship CON2.

The first pad wiring line Dx1 may extend in the first direction (X direction). The first conductive pad MP1 may be a pad positioned in the active region or an inactive region. The first pad connection line 36a may include a first pad connection wiring layer 32a extending in the second direction, and first pad connection via layers 30a and 34a electrically connecting the first pad connection wiring layer 32a with the first pad wiring line Dx1.

Each structure of the embodiment is illustrated in a plan view in FIG. 1A for better understanding of the embodiment but embodiments are not limited thereto. For example, in FIG. 1A, the first active wiring line Mx1 is illustrated not to overlap the second via electrode structure 20b in the third direction (Z direction), and the first pad wiring line Dx1 is illustrated not to overlap the first via electrode structure 20a in the third direction (Z direction). However, in another embodiment, the first active wiring line Mx1 may overlap the second via electrode structure 20b in the third direction (Z direction). In addition, the first pad wiring line Dx1 may overlap the first via electrode structure 20a in the third direction (Z direction). For example, some or all the structures illustrated in FIG. 1A may overlap in the third direction (Z direction).

Herein, the power delivery network layers PDN1a and PDN2a are referred to as the first power delivery network layer PDN1a and the second power delivery network layer PDN2a, respectively. However, the power delivery network layers PDN1a and PDN2a may be referred to as second power delivery network layer PDN1a and first power delivery network layer PDN2a, respectively.

Herein, the arrangement of the first via electrode structure 20a and the second via electrode structure 20b of the via capacitor 1C are described in more detail.

The first via electrode structure 20a and the second via electrode structure 20b may have a first length Xvp1 in the first direction (X direction) and a second length Yvp1 in the second direction (Y direction), respectively. The first via electrode 18a and the second via electrode 18b may have a third length Yv1 in the second direction (Y direction), respectively. In some embodiments, the first length Xvp1 may be in a range of several nanometers to tens of nanometers. In some embodiments, the second length Yvp1 and the third length Yv1 be in a range of several nanometers to tens of nanometers.

The first via electrode structure 20a and the second via electrode structure 20b, or the first via insulating layer 16a and the second via insulating layer 16b, may be spaced apart by a first gap distance SX1 in the first direction (X direction). For example, an outer side surface of the first via electrode structure 20a (e.g., an outer side surface of the first via insulating layer 16a) and an outer side surface of the second via electrode structure 20b (e.g., an outer side surface of the second insulating layer 16b) facing the outer side surface of the first via electrode structure 20a (e.g., an outer side surface of the first via insulating layer 16a) may be spaced apart by the first gap distance SX1. In some embodiments, the closest distance between the first via electrode structure 20a and the second via electrode structure 20b in the first direction may be the first gap distance SX1. In some embodiments, the closest distance in the first direction between the first via electrode structure 20a and the second via electrode structure 20b may be equal to the closest distance in the first direction between the first via insulating layer 16a and the second via insulating layer 16b. The first via electrode 18a and the second via electrode 18b may be spaced apart by a second gap distance SX2 in the first direction (X direction). For example, an outer side surface of the first via electrode 18a and an outer side surface of the second via electrode 18b facing the outer side surface of the first via electrode 18a may be spaced apart by the second gap distance SX2. In some embodiments, the closest distance between the first via electrode 18a and the second via electrode 18b in the first direction may be the second gap distance SX2. In some embodiments, the second gap distance SX2 may be greater than the first gap distance SX1. In some embodiments, the first gap distance SX1 and the second gap distance SX2 may be in a range of several nanometers to tens of nanometers.

A portion of the dielectric layer 12 in FIGS. 2A and 2B, which is arranged between the first via electrode structure 20a and the second via electrode structure 20b in the first direction (X direction), may include a material having a relative dielectric constant ε2. The first via insulating layer 16a, which is arranged between the first via electrode 18a and a portion of the dielectric layer 12 in FIGS. 2A and 2B in the first direction (X direction), may include a material having a relative dielectric constant ε1. The second via insulating layer 16b, which is arranged between the second via electrode 18b and a portion of the dielectric layer 12 in FIGS. 2A and 2B in the first direction (X direction), may include a material having a relative dielectric constant ε1. In some embodiments, the relative dielectric constant ε2 may be greater than the relative dielectric constant ε1. When comparing relative dielectric constants (e.g. relative permittivity), the same parameters may be used (e.g. both may be measured at 20°C for frequencies at or under 1 kHz).

The via capacitor 1C may be implemented by using the first and the second power delivery network layers PDN1a and PDN2a in the integrated circuit device IC1. In addition, the capacitance of the via capacitor 1C may easily be controlled by adjusting the first length Xvpl, the second length Yvpl, the third length Yv1, the first gap distance SX1, the second gap distance SX2 and the relative dielectric constants ε1 and ε2. Accordingly, the degree of freedom in designing the integrated circuit device IC1 according to an embodiment may increase by reducing the area of the via capacitor 1C (e.g. in plan view).

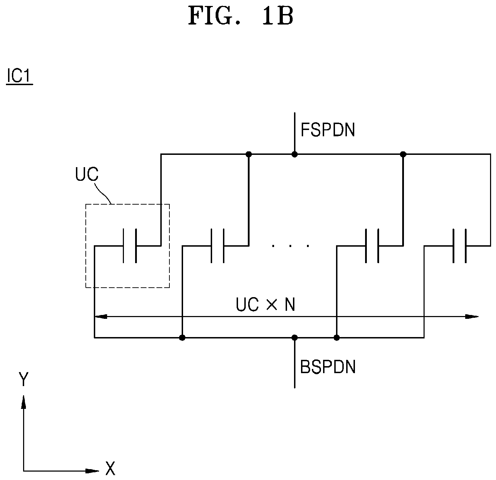

FIG. 1B is a schematic circuit diagram of the integrated circuit device shown in FIG. 1A.

Specifically, the integrated circuit device IC1 may include a unit capacitor UC. The unit capacitor UC may include the via capacitor 1C shown in FIG. 1A. In the integrated circuit device IC1, N unit capacitors UC (N is a positive integer) may be arranged in the first direction (X direction), as expressed by UC x N. In the integrated circuit device IC1, the unit capacitors UC may be electrically connected with one another in parallel. The unit capacitors UC may be arranged in such a configuration that capacitor electrodes (e.g., via electrode structures 20a and 20b) of the neighboring unit capacitors UC face each other in the first direction (X direction).

Upper ends of the unit capacitors UC may be electrically connected to the front side power delivery network layer FSPDN. The front side power delivery network layer FSPDN may be positioned on a front side (or an upper side) of the dielectric layer 12 or the substrate. The front side power delivery network layer FSPDN may correspond to the first power delivery network layer PDN1a in FIG. 1A.

Lower ends of the unit capacitors UC may be electrically connected to a back side power delivery network layer BSPDN. The back side power delivery network layer BSPDN may be positioned on the back side (or the lower side) of the dielectric layer 12 or the substrate. The back side power delivery network layer BSPDN may correspond to the second power delivery network layer PDN2a in FIG. 1A.

FIGS. 2A and 2B and FIGS. 3A and 3B are cross-sectional views of an integrated circuit device including the via capacitor shown in FIGS. 1A and 1B, according to some embodiments of the inventive concept.

Specifically, FIGS. 2A and 2B are cross-sectional views cut along the first direction (X direction) in FIGS. 1A and 1B, and FIGS. 3A and 3B are cross-sectional views cut along the second direction (Y direction) in FIGS. 1A and 1B. Unlike FIG. 1A, the integrated circuit device IC1 in FIGS. 2A and 2B is illustrated including four via electrode structures (20a to 20d) for conveniences' sake.

As described above, the integrated circuit device IC1 may include the dielectric layer 12, the via capacitor 1C, the first power delivery network layer PDN1a, and the second power delivery network layer PDN2a. One end and the other end of the via capacitor 1C may be electrically connected to the first power delivery network layer PDN1a and the second power delivery network layer PDN2a, respectively.

The dielectric layer 12 may include a first surface 12a and a second surface 12b opposite to the first surface 12a. The first surface 12a may be a front surface. The second surface 12b may be a back (rear) surface. A plurality of transistors may be arranged at the same vertical level as the dielectric layer 12. It will be appreciated that terms such as "front", "back", "upper", "lower", "top", "bottom", etc. are relative terms, and do not imply any form of orientation of the device in use. For instance, the front surface may be located further along the third direction than the rear surface. Similarly, features that are "above" other features may be considered to be further along the third direction than the other features.

In some embodiments, the dielectric layer 12 may include an insulating layer. For example, the dielectric layer 12 may include a silicon oxide layer, a silicon nitride layer, a silicon carbide layer, silicon oxycarbide layer, a silicon oxynitride layer, and/or a silicon oxycarbonitride layer, but embodiments are not limited thereto. When the dielectric layer 12 is an insulating layer, first to fourth via insulating layers 16a, 16b, 16c, and 16d may be omitted. In another embodiment, the dielectric layer 12 may include a plurality of layers including different materials in the first direction (X direction) or the third direction (Z direction). In some embodiments, the dielectric layer 12 may include a semiconductor material, such as silicon (Si) or germanium (Ge), but embodiments are not limited thereto. Herein, the dielectric layer 12 may be referred to as a device element.

The via capacitor 1C may be positioned between the first surface 12a and the second surface 12b of the dielectric layer 12. In some embodiments, the via capacitor 1C may be a vertical via capacitor between the first surface 12a and the second surface 12b. In some embodiments, the via capacitor 1C may be a penetrating via capacitor (e.g. a through-chip via capacitor) or a penetrating silicon via capacitor (e.g. through-silicon via capacitor) that extends through (e.g., penetrates through) the dielectric layer 12 between the first surface 12a and the second surface 12b. The via capacitor 1C may include first to fourth via electrode structures 20a to 20d spaced apart from each other in the first direction (X direction) on (e.g., between) the first surface 12a and the second surface 12b.

The first via electrode structure 20a may include a first trench 14a in the dielectric layer 12, a first via insulating layer 16a arranged on an inner wall (e.g., inner sidewall) of the first trench 14a, and a first via electrode 18a on an inner wall (e.g., inner sidewall) of the first via insulating layer 16a. In some embodiments, the first via electrode 18a may fill the remaining portion of the first trench 14a after the formation of the first via insulating layer 16a.

The second via electrode structure 20b may be spaced apart from the first via electrode structure 20a in the first direction (X direction). The second via electrode structure 20b may have the same structure as the first via electrode structure 20a. The second via electrode structure 20a may include a second trench 14b in the dielectric layer 12, a second via insulating layer 16b arranged on an inner wall of the second trench 14b, and a second via electrode 18b filling the second trench 14b and arranged on a side surface of the second via insulating layer 16b.

A third via electrode structure 20c may be spaced apart from the second via electrode structure 20b in the first direction (X direction). The third via electrode structure 20c may have the same structure as the first via electrode structure 20a and the second via electrode structure 20b. The third via electrode structure 20c may include a third trench 14c in the dielectric layer 12, a third via insulating layer 16c arranged on an inner wall of the third trench 14c, and a third via electrode 18c filling the third trench 14c and arranged on a side surface of the third via insulating layer 16c.

The fourth via electrode structure 20d may be spaced apart from the third via electrode structure 20c in the first direction (X direction). The fourth via electrode structure 20d may have the same structure as the first to third via electrode structures 20a to 20c. The fourth via electrode structure 20d may include a fourth trench 14d in the dielectric layer 12, a fourth via insulating layer 16d arranged on an inner wall of the fourth trench 14d, and a fourth via electrode 18d filling the fourth trench 14d and arranged on a side surface of the fourth via insulating layer 16d.

The third and fourth via insulating layers 16c and 16d may include the same material as the first and second via insulating layers 16a and 16b. The third and fourth via electrodes 18c and 18d may include the same material as the first and second via electrodes 18a and 18b.

As shown in FIGS. 2A and 3A, the first power delivery network layer PDN1a may be arranged on the first surface 12a of the dielectric layer 12. The first power delivery network layer PDN1a may include the first active connection line 28a electrically connected to the second via electrode structure 20b through the first active contact CA1. The first power delivery network layer PDN1a may further include the first active wiring line Mx1 electrically connected to the first active connection line 28a.

In some embodiments, as shown in FIG. 3A, a top surface of the first active contact CA1 may be at the same distance in the third direction as a top surface of the second via electrode structure 20b from the second surface 12b of the dielectric layer 12. For example, the top surface of the first active contact CA1 may be at the same distance in the third direction as the first surface 12a of the dielectric layer 12. In some embodiments, unlike FIG. 3A, the top surface of the first active contact CA1 may be positioned higher (e.g., farther in the third direction from the second surface 12b of the dielectric layer 12) than the top surface of the second via electrode structure 20b.

In some embodiments, as shown in FIG. 3A, the first active contact CA1 may be overlapped (e.g., aligned) with the second via electrode structure 20b in the third direction (Z direction). Aligned may mean herein that the first active contact CA1 may be completely overlapped with (e.g., disposed within) the second via electrode structure 20b in the third direction. For example, at least a sidewall of the second via electrode 18b may be aligned with a sidewall of the first active contact CA1 in the third direction. In some embodiments, unlike FIG. 3A, the first active contact CA1 may not be aligned with the second via electrode structure 20b in the third direction (Z direction). In some embodiments, as shown in FIG. 3A, an imaginary center line of the first active contact CA1 extending in the third direction may be shifted in the second direction (Y direction) from an imaginary center line of the second via electrode structure 20b extending in the third direction. The second active contact CA2 may have the same structure as the first active contact CA1, but with electrical connection with the fourth via electrode structure 20d and second active connection line 28b instead of the second via electrode structure 20b and first active connection line 28a.

The first active connection line 28a may include the first active connection wiring layer 24a and the first active connection via layers 22a and 26a. The first active connection via layers 22a and 26a may electrically connect the first active contact CA1 with the first active connection wiring layer 24a and the first active connection wiring layer 24a with the first active wiring line

Mx1.

The first active connection line 28a and the first active wiring line Mx1 may be electrically connected through the active connection relationship CON1 in FIG. 1A. An electrical connection part from the second via electrode structure 20b to the first active wiring line Mx1 through the first active connection line 28a and the first active contact CA1 may be provided as a first resistance component RS1.

The first power delivery network layer PDN1a may also include the second active connection line 28b electrically connected to the fourth via electrode structure 20d through the second active contact CA2, and the second active connection line 28b may be electrically connected to the first active wiring line Mx1.

The second active connection line 28b may include a second active connection wiring layer 24b and second active connection via layers 22b and 26b. The second active connection via layers 22b and 26b may electrically connect the second active contact CA2 with the second active connection wiring layer 24b and the second active connection wiring layer 24b with the first active wiring line Mx1.

The second active connection line 28b and the first active wiring line Mx1 may be electrically connected through the active connection relationship CON1 in FIG. 1A. An electrical connection part from the fourth via electrode structure 20d to the first active wiring line Mx1 through the second active connection line 28b and the second active contact CA2 may be provided as a second resistance component RS2.

In some embodiments, the first active wiring line Mx1 may extend in the first direction (X direction) over the second via electrode structure 20b and the fourth via electrode structure 20d and overlap the second via electrode structure 20b and the fourth via electrode structure 20d in the third direction (Z direction). In some embodiments, the first active wiring line Mx1 may be spaced apart from the second via electrode structure 20b and the fourth via electrode structure 20d in the second direction (Y direction) over the second via electrode structure 20b and the fourth via electrode structure 20d and may extend in the first direction (X direction).

As shown in FIGS. 2B and 3B, the second power delivery network layer PDN2a may be arranged on the second surface 12b of the dielectric layer 12. The second power delivery network layer PDN2a may include the first pad connection line 36a electrically connected to the first via electrode structure 20a through the first conductive pad MP1. The second power delivery network layer PDN2a may further include the first pad wiring line Dx1 electrically connected to the first pad connection line 36a. In some embodiments, the first conductive pad MP1 may be provided in a first passivation layer 38a that is on the second surface 12b of the dielectric layer 12.

The first pad connection line 36a may include the first pad connection wiring layer 32a and the first pad connection via layers 30a and 34a. The first pad connection via layers 30a and 34a may electrically connect the first conductive pad MP1 with the first pad connection wiring layer 32a and the first pad connection wiring layer 32a with the first pad wiring line Dx1. The first pad connection line 36a and the first pad wiring line Dx1 may be electrically connected through the pad connection relationship CON2 in FIG. 1A. An electrical connection part from the first via electrode structure 20a to the first pad wiring line Dx1 through the first pad connection line 36a and the first conductive pad MP1 may be provided as a third resistance component RS3.

In some embodiments, as shown in FIG. 3B, the first conductive pad MP1 may be overlapped (e.g., aligned) with the first via electrode structure 20a in the third direction (Z direction). For example, aligned my mean herein that the first conductive pad MP1 may be completely overlapped with (e.g., disposed within) the first via electrode structure 20a in the third direction. In some embodiments, unlike FIG. 3B, the first conductive pad MP1 may not be aligned with the first via electrode structure 20a in the third direction (Z direction). The second conductive pad MP2 may have the same structure as the first conductive pad MP1, but with electrical connection with the third via electrode structure 20c and the second pad connection line 36b instead of the first via electrode structure 20a and the first pad connection line 36a.

The second power delivery network layer PDN2a may also include a second pad connection line 36b electrically connected to the third via electrode structure 20c through the second conductive pad MP2, and the second pad connection line 36b may be electrically connected to the first pad wiring line Dx1. The second conductive pad MP2 may be provided in the first passivation layer 38a that is on the second surface 12b of the dielectric layer 12.

The second pad connection line 36b may include a second pad connection wiring layer 32b and second pad connection via layers 30b and 34b. The second pad connection via layers 30b and 34b may electrically connect the second conductive pad MP2 with the second pad connection wiring layer 32b and the second pad connection wiring layer 32b with the first pad wiring line Dx1. The second pad connection line 36b and the first pad wiring line Dx1 may be electrically connected through the pad connection relationship CON2 in FIG. 1A. An electrical connection part from the third via electrode structure 20c to the first pad wiring line Dx1 through the second pad connection line 36b and the second conductive pad MP2 may be provided as a fourth resistance component RS4.

In some embodiments, the first pad wiring line Dx1 may extend in the first direction (X direction) under the first via electrode structure 20a and the third via electrode structure 20c and overlap the first via electrode structure 20a and the third via electrode structure 20c in the third direction (Z direction). In some embodiments, the first pad wiring line Dx1 may be spaced apart from the first via electrode structure 20a and the third via electrode structure 20c in the second direction (Y direction) under the first via electrode structure 20a and the third via electrode structure 20c and extend in the first direction (X direction).

For example, in FIGS. 2A and 2B, the first active wiring line Mx1 may overlap the first via electrode structure 20a, the second via electrode structure 20b, the third via electrode structure 20c, the fourth via electrode structure 20d, and the first pad wiring line Dx1 in the third direction (Z direction).

In some embodiments, the sum of the height of the first via electrode structure 20a and the height of the first conductive pad MP1 in the third direction may be a first height Zv1. In some embodiments, the sum of the height of the third via electrode structure 20c and the height of the second conductive pad MP2 in the third direction may be the first height Zv1. The first height Zv1 may be in a range of tens of nanometers to several micrometers. A first capacitor component CP1 may be provided between the first via electrode structure 20a and the second via electrode structure 20b.

A second capacitor component CP2 may be provided between the second via electrode structure 20b and the third via electrode structure 20c. A third capacitor component CP3 may be provided between the third via electrode structure 20c and the fourth via electrode structure 20d. The capacitance of the via capacitor 1C may be controlled by adjusting the first height Zv1. The first to third capacitor components CP1 to CP3 may be determined by the gap distances SX1 and SX2 in FIG. 1A, the relative dielectric constants ε1 and ε2, and the first height Zv1.

In FIGS. 1A to 3B, the via electrode structures 20a, 20b, 20c, and 20d are illustrated to have a length in the first direction (X direction) that is longer than a length in the second direction (Y direction) but embodiments are not limited thereto. In another embodiment, at least one of the via electrode structures 20a, 20b, 20c, and 20d may have the length in the first direction (X direction) that is shorter than or equal to the length in the second direction (Y direction). Those embodiments may be similarly applied to the via electrodes 18a, 18b, 18c, and 18d in the via electrode structures 20a, 20b, 20c, and 20d.

FIGs. 2A and 2B show resistances RS1, RS2, RS3 and RS4, as well as capacitances CP1, CP2 and CP3. It will be appreciated that these labels do not relate to additional components, but instead reflect the electrical properties of the components depicted in these figures. For instance, resistance RS1 represents the resistance across the first active connection line 28a and the first active contact CA1. Similarly, capacitance CP1 represents the capacitance across the first via electrode structure 20a and the second via electrode structure 20b.

Thus, the via capacitor 1C may be implemented by using the first and second power delivery network layers PDN1a and PDN2a, and the capacitance of the via capacitor 1C may be easily controlled by using various variables in the integrated circuit device IC1. Accordingly, the degree of freedom in designing the integrated circuit device IC1 according to an embodiment may increase whilst reducing the area of the via capacitor 1C positioned in a vertical shape in the dielectric layer 12.

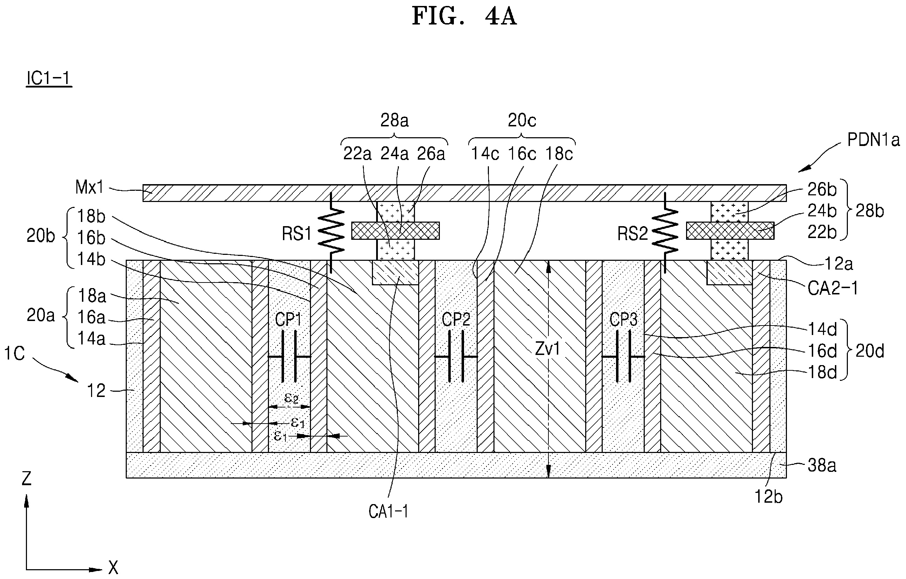

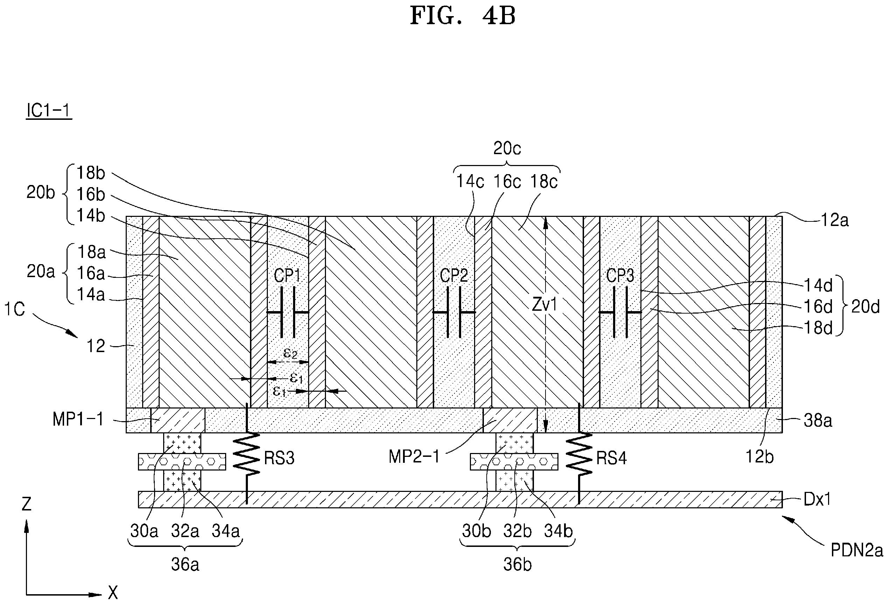

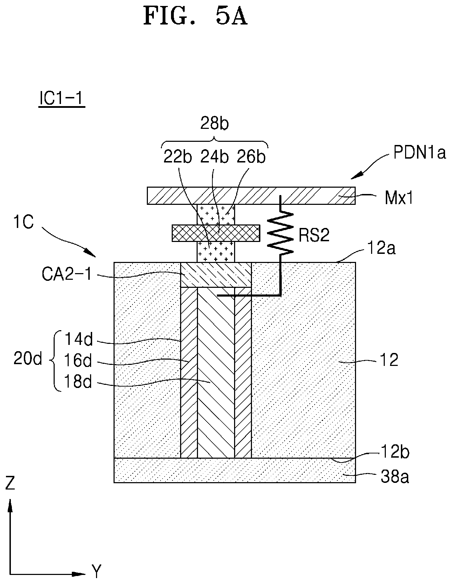

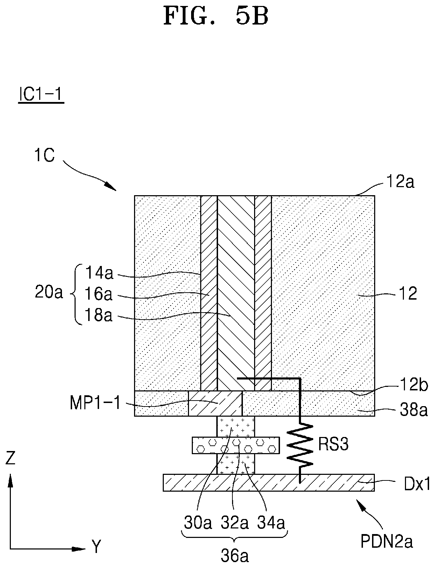

FIGS. 4A and 4B and FIGS. 5A and 5B are cross-sectional views illustrating an integrated circuit device including the via capacitor in FIGS. 1A and 1B, according to some embodiments of the inventive concept.

Specifically, an integrated circuit device IC1-1 may have substantially the same structures as the integrated circuit device IC1 described with reference to FIGS. 2A and 2B and FIGS. 3A and 3B, except for the configurations of the second active contact CA2-1 and the first conductive pad MP1-1 in the second direction (Y direction).

FIGS. 4A and 4B are cross-sectional views cut along the first direction (X direction) in FIGS. 1A and 1B and FIGS. 5A and 5B are cross-sectional views cut along the second direction (Y direction) in FIGS. 1A and 1B. In FIGS. 4A and 4B and FIGS. 5A and 5B, the same descriptions as those given with reference to FIGS. 2A and 2B and FIGS. 3A and 3B are briefly given or omitted.

The integrated circuit device IC1-1 may include the dielectric layer 12, the via capacitor 1C, the first power delivery network layer PDN1a, and the second power delivery network layer PDN2a. The via capacitor 1C may include the first to fourth via electrode structures 20a to 20d spaced apart from each other in the first direction (X direction) on (e.g., between) the first surface 12a and the second surface 12b of the dielectric layer 12.

As shown in FIGS. 4A and 5A, the first power delivery network layer PDN1a may be on the first surface 12a of the dielectric layer 12. In some embodiments, as shown in FIG. 5A, the second active contact CA2-1 may be on the top surface of the fourth via electrode structure 20d.

In some embodiments, as shown in FIG. 5A, the second active contact CA2-1 may be overlapped (e.g., aligned) with the fourth via electrode structure 20d in the third direction (Z direction). For example, aligned may mean herein that the second active contact CA2-1 may be completely overlapped with (e.g., disposed within) the fourth via electrode structure 20d in the third direction. In some embodiments, opposing (e.g., both) sidewalls of the fourth via electrode structure 20d may be aligned with sidewalls of the second active contact CA2-1 in the third direction, respectively. A first active contact CA1-1 may have the same structure as the second active contact CA2-1, but with electrical connection with the first active connection line 28a and the second via electrode structure 20b instead of the second active connection line 28b and the fourth via electrode structure 20d.

As shown in FIGS. 4B and 5B, the second power delivery network layer PDN2a may be arranged on the second surface 12b of the dielectric layer 12. In some embodiments, as shown in FIG. 5B, the first conductive pad MP1-1 may not be aligned with the first via electrode structure 20a in the third direction (Z direction). For example, at least a portion of the first conductive pad MP1-1 may not be overlapped with the first via electrode structure 20a in the third direction. The first conductive pad MP1-1 may be shifted from the center of the first via electrode structure 20a in the second direction (Y direction). The second conductive pad MP2-1 may have the same structure as the first conductive pad MP1-1. As describe above, the same structure herein may mean that the same structure except its location in a certain direction (e.g., second direction) and its electrical connection with adjacent elements.

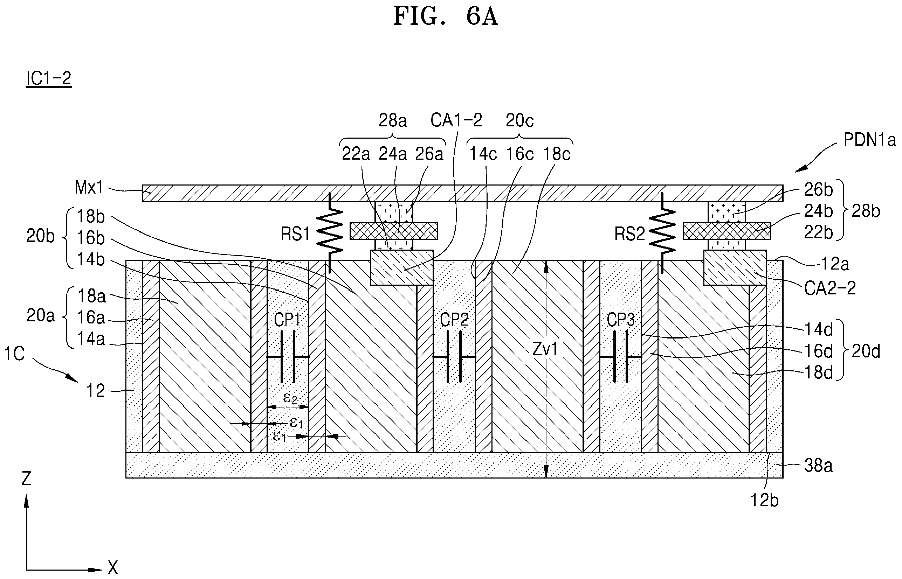

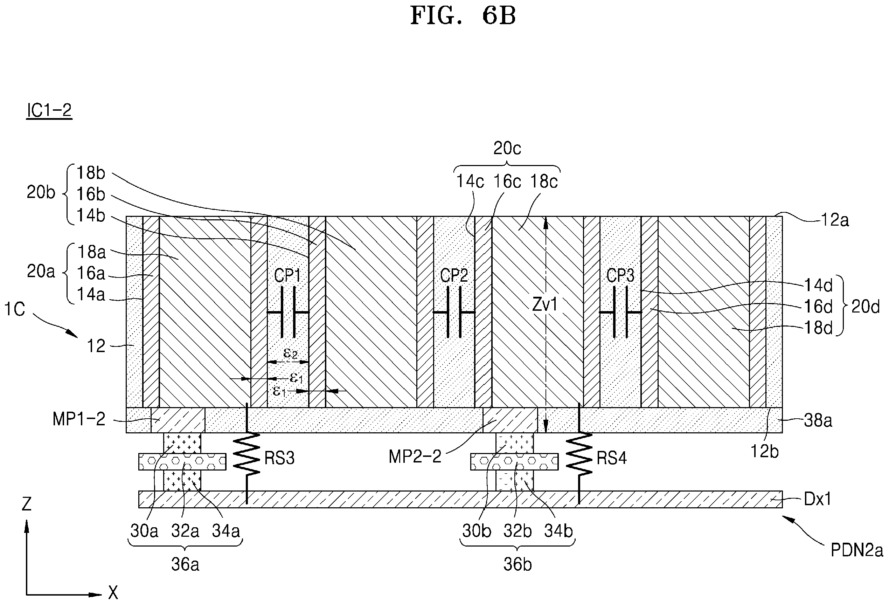

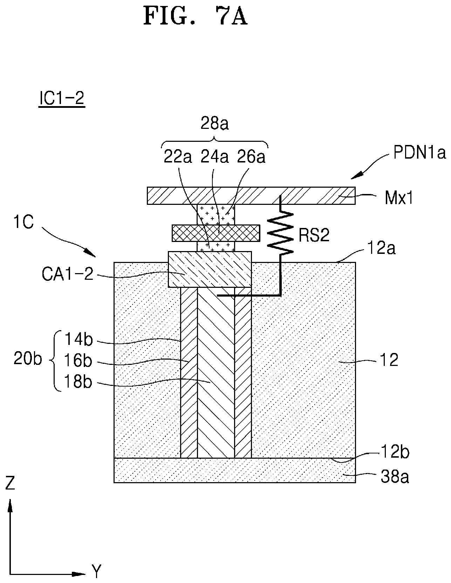

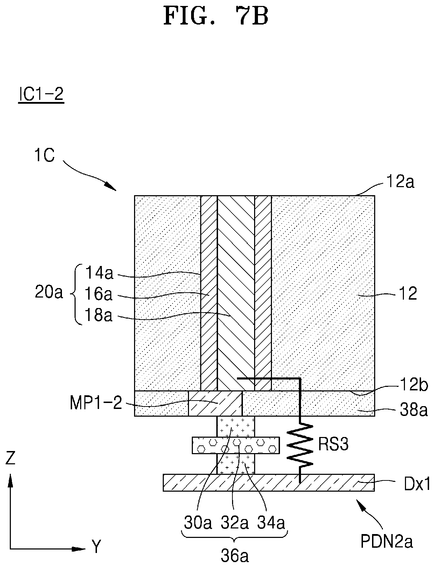

FIGS. 6A and 6B and FIGS. 7A and 7B are cross-sectional views illustrating an integrated circuit device including the via capacitor in FIGS. 1A and 1B, according to some embodiments of the inventive concept.

Specifically, an integrated circuit device IC1-2 may have substantially the same structures as the integrated circuit device IC1 described with reference to FIGS. 2A and 2B and FIGS. 3A and 3B, except for the configurations of the first active contact CA1-2 and the second active contact CA2-2 in the first direction (X direction) and the second direction (Y direction) and the first conductive pad MP1-2 in the second direction (Y direction).

FIGS. 6A and 6B are cross-sectional views cut along the first direction (X direction) in FIGS. 1A and 1B and FIGS. 7A and 7B are cross-sectional views cut along the second direction (Y direction) in FIGS. 1A and 1B. In FIGS. 6A and 6B and FIGS. 7A and 7B, the same descriptions as those given with reference to FIGS. 2A and 2B and FIGS. 3A and 3B are briefly given or omitted.

The integrated circuit device IC1-2 may include the dielectric layer 12, the via capacitor 1C, the first power delivery network layer PDN1a, and the second power delivery network layer PDN2a. The via capacitor 1C may include the first to fourth via electrode structures 20a to 20d spaced apart from each other in the first direction (X direction) on (e.g., between) the first surface 12a and the second surface 12b.

As shown in FIGS. 6A and 7A, the first power delivery network layer PDN1a may be arranged on the first surface 12a of the dielectric layer 12. In some embodiments, as shown in FIG. 6A, the top surfaces of the first active contact CA1-2 and the second active contact CA2-2 may be positioned higher (e.g., farther from the second surface 12b of the dielectric layer 12 in the third direction) than the top surfaces of the second via electrode structure 20b and the fourth via electrode structure 20d, respectively. As shown in FIG. 6A, the first active contact CA1-2 and the second active contact CA2-2 may be positioned at a side portion of the second via electrode structure 20b and the fourth via electrode structure 20d, respectively. For example, a sidewall of the first active contact CA1-2 may be aligned with a sidewall of the second via electrode structure 20b in the third direction. For example, aligned may mean herein that the first active contact CA1-2 may be completely overlapped with (e.g., disposed within) the second via electrode structure 20b in the third direction. In some embodiments, a sidewall of the second active contact CA2-2 may be aligned with a sidewall of the fourth via electrode structure 20d in the third direction. Element A may be referred to as aligned with element B when the element A is completely overlapped with the element B in a certain direction (e.g., third direction).

In some embodiments, as shown in FIG. 7A, the first active contact CA1-2 may not be aligned with the second via electrode structure 20b in the third direction (Z direction). Element A may be referred to as "not aligned" with element B when the element A is not completely overlapped with element B in a certain direction (e.g., third direction). For example, at least a portion of the first active contact CA1-2 may not be overlapped with the second via electrode structure 20b in the third direction. The second active contact CA2-2 may have the same structure as the first active contact CA1-2.

As shown in FIGS. 6B and 7B, the second power delivery network layer PDN2a may be arranged on the second surface 12b of the dielectric layer 12. In some embodiments, as shown in FIG. 7B, the first conductive pad MP1-2 may not be aligned with the first via electrode structure 20a in the third direction (Z direction). For example, an imaginary center line of the first conductive pad MP1-2 extending in the third direction may be shifted from an imaginary center line of the first via electrode structure 20a extending in the third direction in the second direction (Y direction). The second conductive pad MP2-2 may have the same structure as the first conductive pad MP1-2.

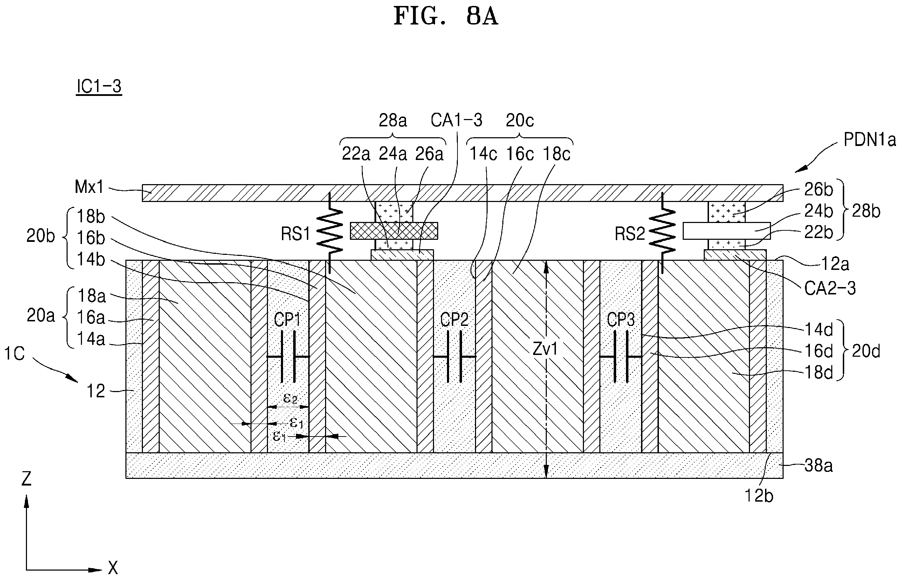

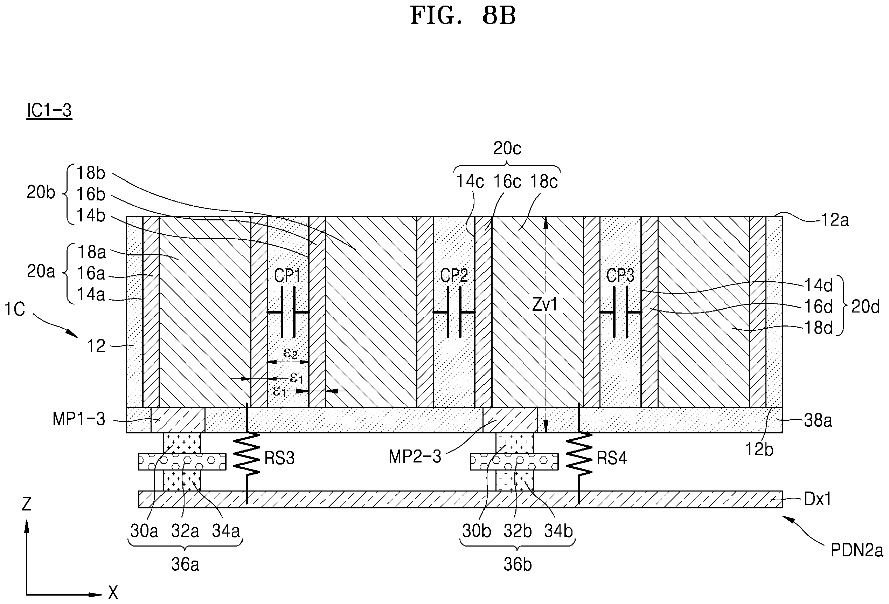

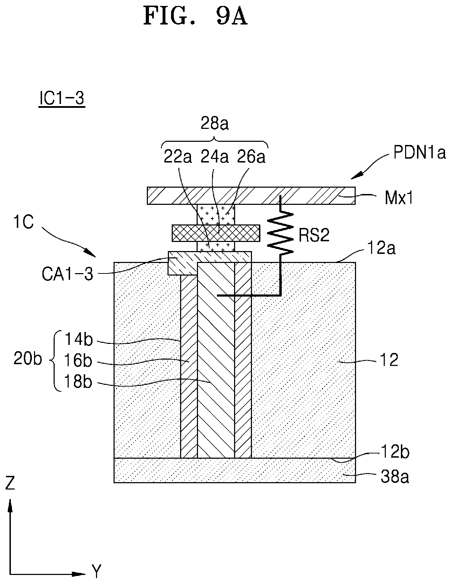

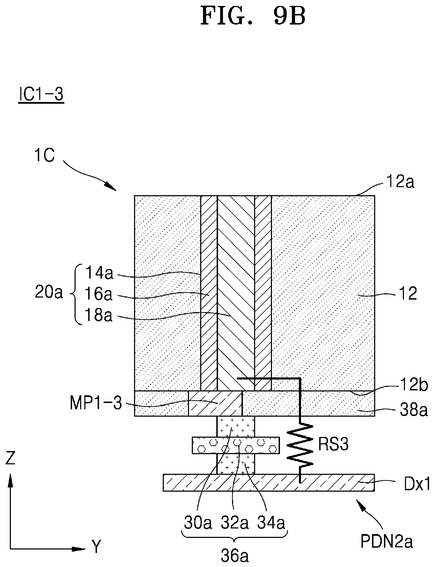

FIGS. 8A and 8B and FIGS. 9A and 9B are cross-sectional views illustrating an integrated circuit device including the via capacitor in FIGS. 1A and 1B, according to some embodiments of the inventive concept.

Specifically, an integrated circuit device IC1-3 may have substantially the same structures as the integrated circuit device IC1 described with reference to FIGS. 2A and 2B and FIGS. 3A and 3B, except for the configurations of the first active contact CA1-3 and the second active contact CA2-3 in the first direction (X direction) and the second direction (Y direction) and the first conductive pad MP1-3 in the second direction (Y direction).

FIGS. 8A and 8B are cross-sectional views cut along the first direction (X direction) in FIGS. 1A and 1B and FIGS. 9A and 9B are cross-sectional views cut along the second direction (Y direction) in FIGS. 1A and 1B. In FIGS. 6A and 6B and FIGS. 7A and 7B, the same descriptions as those given with reference to FIGS. 2A and 2B and FIGS. 3A and 3B are briefly given or omitted.

The integrated circuit device IC1-3 may include the dielectric layer 12, the via capacitor 1C, the first power delivery network layer PDN1a, and the second power delivery network layer PDN2a. The via capacitor 1C may include the first to fourth via electrode structures 20a to 20d spaced apart from each other in the first direction (X direction) on (e.g., between) the first surface 12a and the second surface 12b.

As shown in FIGS. 8A and 9A, the first power delivery network layer PDN1a may be arranged on the first surface 12a of the dielectric layer 12. In some embodiments, as shown in FIG. 8A, the first active contact CA1-3 and the second active contact CA2-3 may be positioned on the second via electrode structure 20b and the fourth via electrode structure 20d, respectively. As shown in FIG. 8A, the first active contact CA1-3 and the second active contact CA2-3 may be positioned on the second via electrode structure 20b and the fourth via electrode structure 20d, respectively, at a side portion thereof. For example, imaginary center lines of the first active contact CA1-3 and the second active contact CA2-3 extending in the third direction may be shifted in the first direction (X direction) from imaginary center lines of the second via electrode structure 20b and the fourth via electrode structure 20d extending in the third direction.

In some embodiments, as shown in FIG. 9A, the first active contact CA1-3 may partially overlap the second via electrode structure 20b in the third direction (Z direction). The first active contact CA1-3 may include a recess portion that is recessed from the surface of the second via electrode structure 20b in the third direction (Z direction). For example, the recess portion of the first active contact CA1-3 may be in contact with an upper surface and/or a sidewall of the second via electrode structure 20b (e.g., an upper surface and/or a sidewall of the second via electrode 18b and an upper surface of the second via insulating layer 16b). The second active contact CA2-3 may have the same structure as the first active contact CA1-3.

As shown in FIGS. 8B and 9B, the second power delivery network layer PDN2a may be arranged on the second surface 12b of the dielectric layer 12. In some embodiments, as shown in FIG. 9B, the first conductive pad MP1-3 may not be aligned with the first via electrode structure 20a in the third direction (Z direction). An imaginary center line of the first conductive pad MP1-3 extending in the third direction may be shifted in the second direction (Y direction) from an imaginary center line of the first via electrode structure 20a extending in the third direction. The second conductive pad MP2-3 may have the same structure as the first conductive pad MP1-3.

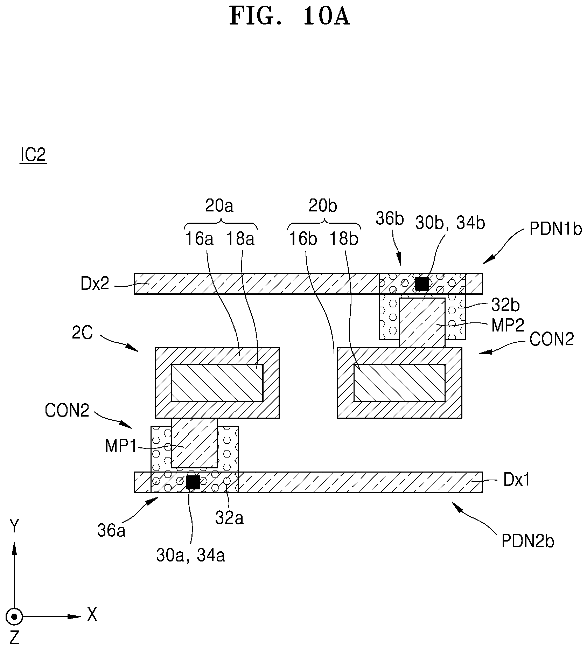

FIG. 10A is a schematic partial layout of an integrated circuit device including a via capacitor according to some embodiments of the inventive concept.

Specifically, an integrated circuit device IC2 may have the same structures as the integrated circuit device IC1 in FIG. 1A except for the configurations of the first power delivery network layer PDN1b. In FIG. 10A, the same or similar elements in FIG. 1A represent the same or similar configurations. In FIG. 10A, the same descriptions as those given with reference to FIG. 1A are briefly given or omitted.

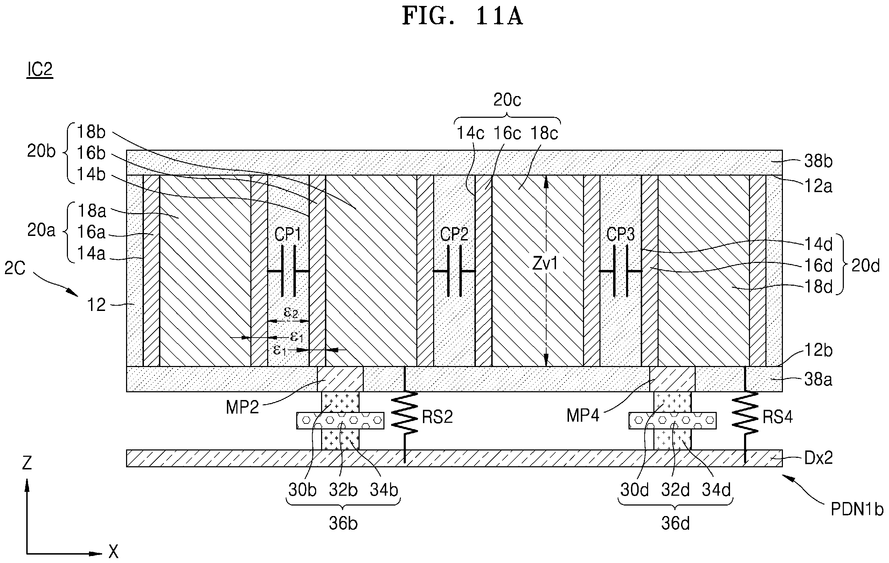

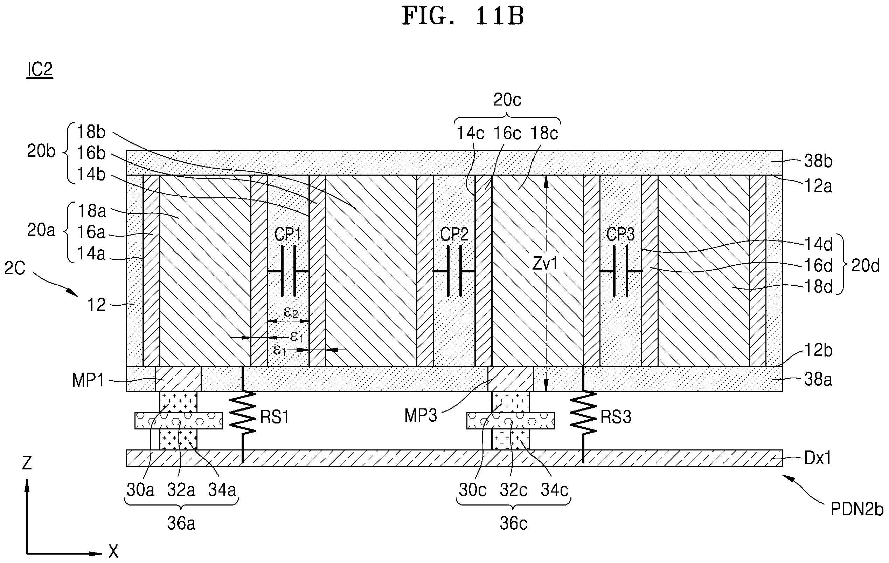

The integrated circuit device IC2 may include a dielectric layer 12 in FIGS. 11A and 11B, a via capacitor 2C, a first power delivery network layer PDN1b, and a second power delivery network layer PDN2b. The integrated circuit device IC2 may include the via capacitor 2C.

The via capacitor 2C may be implemented by using the first power delivery network layer PDN1b and the second power delivery network layer PDN2b in the integrated circuit device IC2. The via capacitor 2C may be positioned in at least one of a cell region and a peripheral circuit region of the integrated circuit device IC2.

A plurality of transistors may be arranged at the level (e.g., same level) of the dielectric layer 12 in FIGS. 11A and 11B. The via capacitor 2C may include a first via electrode structure 20a and a second via electrode structure 20b spaced apart from each other in the first direction (X direction).

The first via electrode structure 20a may include a first via electrode 18a and a first via insulating layer 16a. The second via electrode structure 20b may include a second via electrode 18b and a second via insulating layer 16b. In a plan view, a single capacitor component may be positioned between the first via electrode structure 20a and the second via electrode structure 20b.

The first power delivery network layer PDN1b and the second power delivery network layer PDN2b may be at the same level in the third direction (Z direction). For example, the first and second power delivery network layers PDN1b and PDN2b may be on the second surface 12b of the dielectric layer 12. The first power delivery network layer PDN1b may include a second pad connection line 36b electrically connected to the second via electrode structure 20b through a second conductive pad MP2, and a second pad wiring line Dx2 electrically connected to the second pad connection line 36b.

The second pad connection line 36b may include a second pad connection wiring layer 32b and second pad connection via layers 30b and 34b. The second pad connection via layers 30b and 34b may electrically connect the second via electrode structure 20b with the second pad connection wiring layer 32b and the second pad connection wiring layer 32b with the second pad wiring line Dx2.

The first power delivery network layer PDN1b may be a back side power delivery network layer BSPDN that is provided on the rear surface (or a lower/back surface, e.g., the second surface 12b) of the dielectric layer 12 in FIGS. 2A, 2B, 3A, and 3B, as described below. The electrical connection of the second conductive pad MP2 with the second pad wiring line Dx2 through the second pad connection line 36b is referred to as pad connection relationship CON2.

The second pad wiring line Dx2 extends in the first direction (X direction). The second conductive pad MP2 may be a pad in an active region or an inactive region. In FIG. 10A, the second pad wiring line Dx2 is illustrated not to overlap the second via electrode structure 20b in a plan view, but the second pad wiring line Dx2 may overlap the second via electrode structure 20b.

The second power delivery network layer PDN2b may have substantially the same structures as the second power delivery network layer PDN2a in FIG. 1A. The second power delivery network layer PDN2b may include a first pad connection line 36a electrically connected to the first via electrode structure 20a through a first conductive pad MP1, and a first pad wiring line Dx1 electrically connected to the first pad connection line 36a.

The second power delivery network layer PDN2b may be a back side power delivery network layer BSPDN that is provided on the rear surface (or a lower/back surface, e.g., the second surface 12b) of the dielectric layer 12 in FIGS. 2A, 2B, 3A, and 3B, as described below. The electrical connection of the first conductive pad MP1 with the first pad wiring line Dx1 through the first pad connection line 36a is referred to as pad connection relationship CON2.

The first pad wiring line Dx1 may extend in the first direction (X direction). The first conductive pad MP1 may be a pad in an active region or an inactive region. The first pad connection line 36a may include a first pad connection wiring layer 32a and first pad connection via layers 30a and 34a extending in the second direction. The first pad connection via layers 30a and 34a may electrically connect the first conductive pad MP1 with the first pad connection wiring layer 32a and the first pad connection wiring layer 32a with the first pad wiring line Dx1.

The arrangement of the first via electrode structure 20a and the second via electrode structure 20b of the via capacitor 2C may be the same as that of the via capacitor 1C in FIG. 1A. In addition, the integrated circuit device IC2 may easily control the capacitance of the via capacitor 2C by adjusting the first length Xvpl, the second length Yvpl, the third length Yv1, the first gap distance SX1, the second gap distance SX2, and the relative dielectric constants ε1 and ε2, as described in detail with reference to in FIG. 1A. Accordingly, the degree of freedom in designing the integrated circuit device IC2 according to an embodiment may increase by reducing the area of the via capacitor 2C.

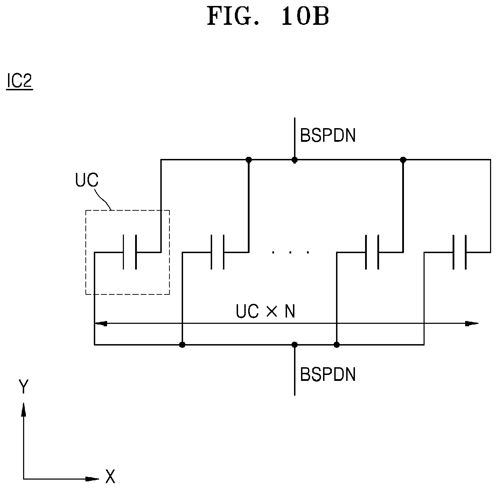

FIG. 10B is a schematic circuit diagram of the integrated circuit device shown in FIG. 10A

Specifically, the integrated circuit device IC2 may include a unit capacitor UC. The unit capacitor UC may include the via capacitor 2C shown in FIG. 10A. In the integrated circuit device IC2, N unit capacitors UC (N is a positive integer) may be arranged in the first direction (X direction), as expressed by UC x N. In the integrated circuit device IC2, the unit capacitors UC may be electrically connected with one another in parallel. The unit capacitor UC may be arranged in such a configuration that capacitor electrodes (e.g., via electrode structures 20a and 20b) of the neighboring unit capacitors UC face each other in the first direction (X direction).

First ends of the unit capacitors UC may be electrically connected to the back side power delivery network layer BSPDN. The back side power delivery network layer BSPDN may be positioned on the back surface (or the lower/back surface, e.g., the second surface 12b) of the dielectric layer 12 or the substrate. The back side power delivery network layer BSPDN may correspond to the first power delivery network layer PDN1b in FIG. 10A.

Second ends of the unit capacitors UC (opposite to the first ends) may be electrically connected to the back side power delivery network layer BSPDN. The back side power delivery network layer BSPDN may be positioned on the back surface (or the lower/back surface, e.g., the second surface 12b) of the dielectric layer 12 or the substrate. The back side power delivery network layer BSPDN may correspond to the second power delivery network layer PDN2b in FIG. 10A.

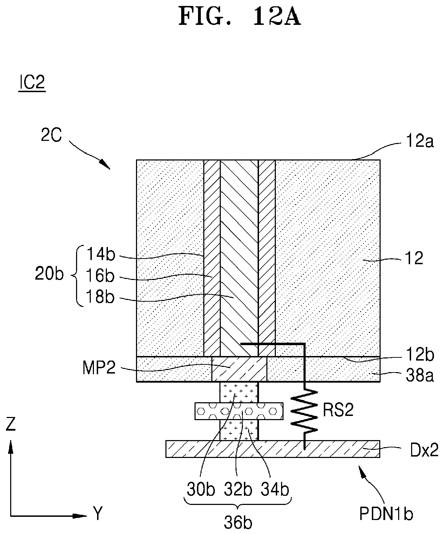

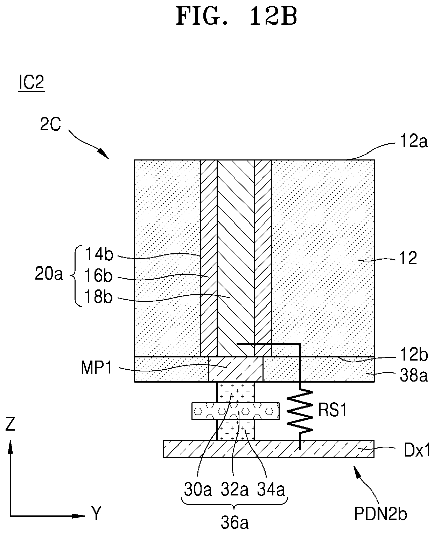

FIGS. 11A and 11B and FIGS. 12A and 12B are cross-sectional views of an integrated circuit device including the via capacitor shown in FIGS. 10A and 10B, according to some embodiments of the inventive concept.

Specifically, FIGS. 11A and 11B are cross-sectional views cut along the first direction (X direction) in FIGS. 10A and 10B, and FIGS. 12A and 12B are cross-sectional views cut along the second direction (Y direction) in FIGS. 10A and 10B. Unlike FIG. 10A, the integrated circuit device IC2 in FIGS. 11A and 11B is illustrated including four via electrode structures (20a to 20d) for conveniences' sake.

The integrated circuit device IC2 may have the same structures as the integrated circuit devices IC1 in FIGS. 2A, 2B, 3A, and 3B, except for the configurations of the first power delivery network layer PDN1b. In FIGS. 11A and 11B and FIGS. 12A and 12B, the same or similar elements in FIGS. 2A and 2B and FIGS. 3A and 3B represent the same or similar configurations. In FIGS. 11A and 11B and FIGS. 12A and 12B, the same descriptions as described with reference to FIGS. 2A and 2B and FIGS. 3A and 3B are briefly given or omitted.

The integrated circuit device IC2 may include the dielectric layer 12, the via capacitor 2C, the first power delivery network layer PDN1b, and the second power delivery network layer PDN2b. The via capacitor 2C may be arranged on (e.g., between) the first surface 12a and the second surface 12b. The via capacitor 2C may include the first to fourth via electrode structures 20a to 20d spaced apart from each other in the first direction (X direction).

As shown in FIGS. 11A and 12A, the first power delivery network layer PDN1b may be arranged on the second surface 12b of the dielectric layer 12. The first power delivery network layer PDN1b may include the second pad connection line 36b electrically connected to the second via electrode structure 20b through the second conductive pad MP2 and the second pad wiring line Dx2 electrically connected to the second pad connection line 36b. The second conductive pad MP2 may be provided in a first passivation layer 38a that is on the second surface 12b of the dielectric layer 12.

The second pad connection line 36b may include the second pad connection wiring layer 32b and the second pad connection via layer 30b and 34b that electrically connects the second pad connection wiring layer 32b to the second pad wiring line Dx2. The second pad connection line 36b and the second pad wiring line Dx2 may be electrically connected through the second conductive pad MP2 the pad connection relationship CON2 in FIG. 10A. An electrical connection part from the second via electrode structure 20b to the second pad wiring line Dx2 through the second pad connection line 36b and the second conductive pad MP2 may be provided as a second resistance component RS2. The second pad wiring line Dx2 may extend in the first direction (X direction). The second conductive pad MP2 may be a pad in an active region or an inactive region.

In some embodiments, as shown in FIG. 12A, the second conductive pad MP2 may be aligned with the second via electrode structure 20b in the third direction (Z direction). In some embodiments, unlike FIG. 12A, the second conductive pad MP2 may not be aligned with the second via electrode structure 20b in the third direction (Z direction). The second conductive pad MP2 may have the same structure as the fourth conductive pad MP4.

The first power delivery network layer PDN1b may include the fourth pad connection line 36d electrically connected to the fourth via electrode structure 20d through the fourth conductive pad MP4, and the fourth pad connection line 36d may be electrically connected to the second pad wiring line Dx2. The fourth conductive pad MP4 may be provided in the first passivation layer 38a that is on the second surface 12b of the dielectric layer 12.

The fourth pad connection line 36d may include a fourth pad connection wiring layer 32d and fourth pad connection via layers 30d and 34d that electrically connect the fourth pad connection wiring layer 32d with the second pad wiring line Dx2. The fourth pad connection line 36d and the second pad wiring line Dx2 may be electrically connected through the pad connection relationship CON2 in FIG. 4. An electrical connection part from the fourth via electrode structure 20d to the second pad wiring line Dx2 through the fourth pad connection line 36d and fourth conductive pad MP4 may be provided as a fourth resistance component RS4. The fourth conductive pad MP4 may be a pad in an active region or an inactive region.

In some embodiments, the second pad wiring line Dx2 may extend in the first direction (X direction) under the second via electrode structure 20b and the fourth via electrode structure 20d. In some embodiments, the second pad wiring line DX2 may be spaced apart from the second via electrode structure 20b and the fourth via electrode structure 20d in the second direction (Y direction) under the second via electrode structure 20b and the fourth via electrode structure 20d and may extend in the first direction (X direction).

As shown in FIGS. 11B and 12B, the second power delivery network layer PDN2b may be arranged on the second surface 12b of the dielectric layer 12. The second power delivery network layer PDN2b may have the same structures as the second power delivery network layer PDN2a shown in FIGS. 2B and 3B. The second power delivery network layer PDN2b may include the first pad connection line 36a electrically connected to the first via electrode structure 20a through the first conductive pad MP1, and the first pad wiring line Dx1 electrically connected to the first pad connection line 36a. The first conductive pad MP1 may be provided in the first passivation layer 38a that is on the second surface 12b of the dielectric layer 12.

The first pad connection line 36a may include the first pad connection wiring layer 32a and the first pad connection via layers 30a and 34a. The first pad connection via layers 30a and 34a may electrically connect the first conductive pad MP1 with the first pad connection wiring layer 32a and the first pad connection wiring layer 32a with the first pad wiring line Dx1.

The first pad connection line 36a and the first pad wiring line Dx1 may be electrically connected through the pad connection relationship CON2 in FIG. 1. An electrical connection part from the first via electrode structure 20a to the first pad wiring line Dx1 through the first pad connection line 36a and the first conductive pad MP1 may be provided as a first resistance component RS1.

The second power delivery network layer PDN2b may also include a third pad connection line 36c electrically connected to the third via electrode structure 20c through a third conductive pad MP3, and the third pad connection line 36c may be electrically to the first pad wiring line Dx1. The third conductive pad MP3 may be provided in the first passivation layer 38a that is on the second surface 12b of the dielectric layer 12.

The third pad connection line 36c may include a third pad connection wiring layer 32c and third pad connection via layers 30c and 34c that electrically connect the third pad connection wiring layer 32c with the first pad wiring line Dx1. The third pad connection line 36c and the first pad wiring line Dx1 may be electrically connected through the pad connection relationship CON2 in FIG. 10A. An electrical connection part from the third via electrode structure 20c to the first pad wiring line Dx1 through the third pad connection line 36c and the third conductive pad MP3 may be provided as a third resistance component RS3.

A first capacitor component CP1 may be provided between the first via electrode structure 20a and the second via electrode structure 20b. A second capacitor component CP2 may be provided between the second via electrode structure 20b and the third via electrode structure 20c. A third capacitor component CP3 may be provided between the third via electrode structure 20c and the fourth via electrode structure 20d.

Thus, the via capacitor 2C may be implemented by using the first and second power delivery network layers PDN1b and PDN2b, and the capacitance of the via capacitor 2C may be easily controlled by using various variables in the integrated circuit device IC2. Accordingly, the degree of freedom in designing the integrated circuit device IC2 according to an embodiment may increase by reducing the area of the via capacitor 2C.

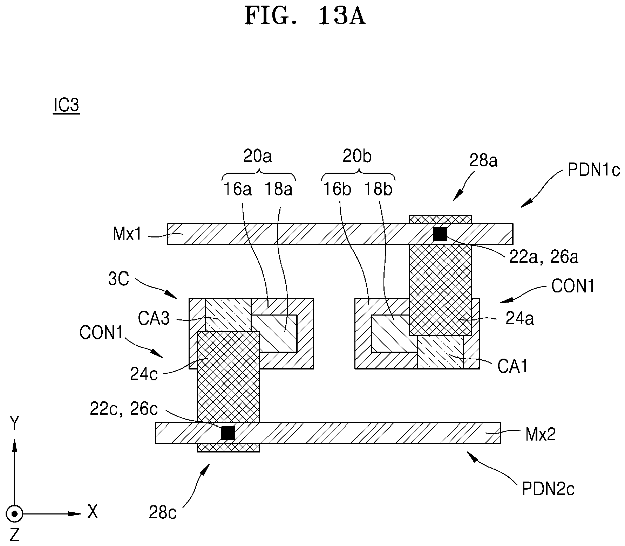

FIG. 13A is a schematic partial layout of an integrated circuit device including a via capacitor according to some embodiments of the inventive concept.

Specifically, an integrated circuit device IC3 may have the same structures as the integrated circuit device IC1 in FIG. 1A, except for the configurations of the second power delivery network layer PDN2c. In FIG. 13A, the same or similar elements in FIG. 1A represent the same or similar configurations. In FIG. 13A, the same descriptions as those given with reference to FIG. 1A are briefly given or omitted.

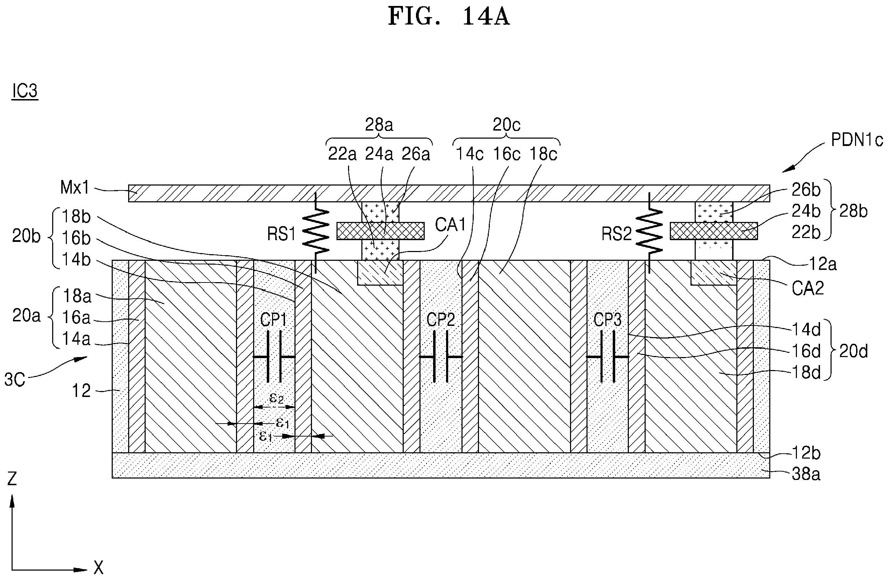

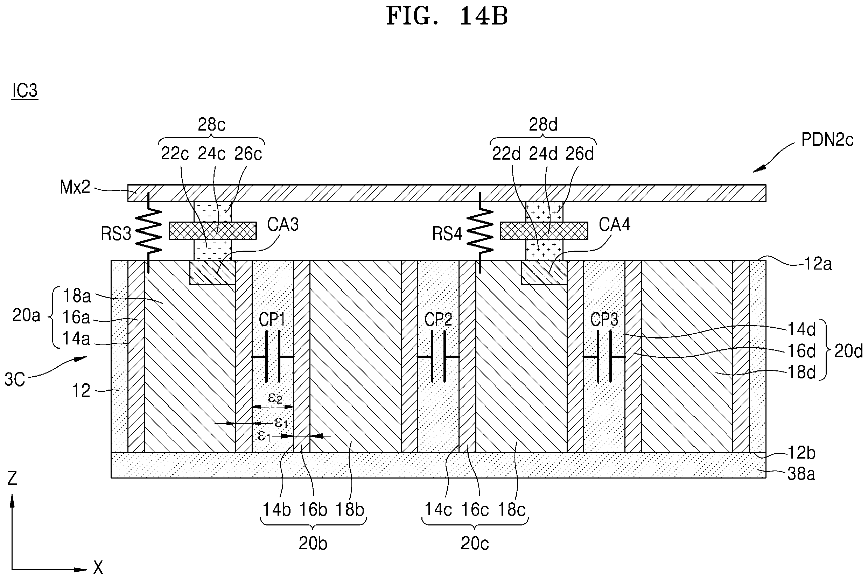

The integrated circuit device IC3 may include a dielectric layer 12 in FIGS. 14A and 14B, a via capacitor 3C, a first power delivery network layer PDN1c, and a second power delivery network layer PDN2c. The integrated circuit device IC3 may include the via capacitor 3C.

The via capacitor 3C may be implemented by using the first power delivery network layer PDN1c and the second power delivery network layer PDN2c in the integrated circuit device IC3. The via capacitor 3C may be positioned in at least one of a cell region and a peripheral circuit region of the integrated circuit device IC3.

A plurality of transistors may be arranged at the level (e.g., same level) of the dielectric layer 12 in FIGS. 14A and 14B. The via capacitor 3C may include a first via electrode structure 20a and a second via electrode structure 20b spaced apart from each other in the first direction (X direction). The first via electrode structure 20a may include a first via electrode 18a and a first via insulating layer 16a. The second via electrode structure 20b may include a second via electrode 18b and a second via insulating layer 16b. In a plan view, a single capacitor component may be positioned between the first via electrode structure 20a and the second via electrode structure 20b.

The first power delivery network layer PDN1c may have the same structures as the first power delivery network layer PDN1a shown in FIG. 1A. The first power delivery network layer PDN1c may include a first active connection line 28a electrically connected to the second via electrode structure 20b through a first active contact CA1, and a first active wiring line Mx1 electrically connected to the first active connection line 28a.

The first power delivery network layer PDN1c may be a front power delivery network layer FSPDN that is provided on the front side (e.g., first surface 12a) of the dielectric layer 12 in FIGS. 2A, 2B, 3A, and 3B, as described below. The electrical connection of the first active contact CA1 with the first active wiring line Mx1 through the first active connection line 28a is referred to as active connection relationship CON1.

The first active wiring line Mx1 may extend in the first direction (X direction). The first active contact CA1 may be positioned in an active region of the dielectric layer 12 in FIGS. 14A and 14B. The first active connection line 28a may include a first active connection wiring layer 24a extending in the second direction, and first active connection via layers 22a and 26a electrically connecting the first active connection wiring layer 24a with the first active wiring line Mx1.

The second power delivery network layer PDN2c may include a third active connection line 28c electrically connected to the first via electrode structure 20a through a third active contact CA3, and a second active wiring line Mx2 electrically connected to the third active connection line 28c. The second power delivery network layer PDN2c may be a front power delivery network layer FSPDN that is provided on the front side (e.g., first surface 12a) of the dielectric layer 12 in FIGS. 2A, 2B, 3A, and 3B, as described below. The electrical connection of the third active contact CA3 with the second active wiring line Mx2 through the third active connection line 28c is referred to as active connection relationship CON1.

The second active wiring line Mx2 may extend in the first direction (X direction). The third active contact CA3 may be positioned in an active region of the dielectric layer 12 in FIGS. 14A and 14B. The third active connection line 28c may include a third active connection wiring layer 24c extending in the second direction, and third active connection via layers 22c and 26c electrically connecting the third active connection wiring layer 24c with the second active wiring line Mx2. In FIG. 13A, the second active wiring line Mx2 is illustrated not to overlap the first via electrode structure 20a in a plan view, but the first active wiring line Mx2 may overlap the first via electrode structure 20a in a plan view.

The arrangement of the first via electrode structure 20a and the second via electrode structure 20b of the via capacitor 3C may be the same as that of the via capacitor 1C in FIG. 1A. Thus, the via capacitor 3C may be implemented by using the first and second power delivery network layers PDN1c and PDN2c in the integrated circuit device IC3.

In addition, the integrated circuit device IC3 may easily control the capacitance of the via capacitor 3C by adjusting the first length Xvpl, the second length Yvpl, the third length Yv1, the first gap distance SX1, the second gap distance SX2, and the relative dielectric constants ε1 and ε2, as described in detail with reference to in FIG. 1A. Accordingly, the degree of freedom in designing the integrated circuit device IC3 according to an embodiment may increase by reducing the area of the via capacitor 3C.

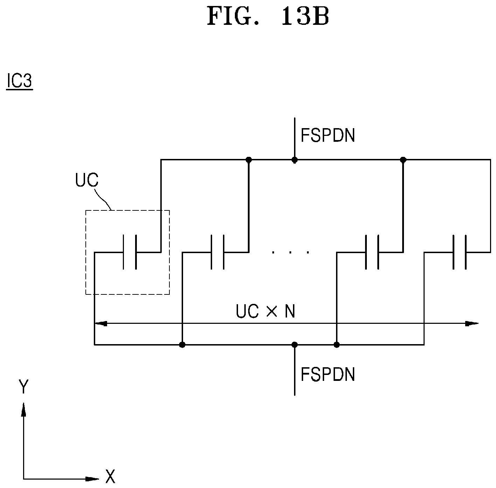

FIG. 13B is a schematic circuit diagram of the integrated circuit device shown in FIG. 13A.

Specifically, the integrated circuit device IC3 may include a unit capacitor UC. The unit capacitor UC may include the via capacitor 3C shown in FIG. 13A. In the integrated circuit device IC3, N unit capacitors UC (N is a positive integer) may be arranged in the first direction (X direction), as expressed by UC x N. In the integrated circuit device IC3, the unit capacitors UC may be electrically connected with one another in parallel. The unit capacitors UC may be arranged in such a configuration that capacitor electrodes (e.g., via electrode structures 20a and 20b) of the neighboring unit capacitors UC face each other in the first direction (X direction).

First ends of the unit capacitors UC may be electrically connected to the front side power delivery network layer FSPDN. The front side power delivery network layer FSPDN may be positioned on a front side (or an upper side, e.g., first surface 12a) of the dielectric layer 12 or the substrate. The front side power delivery network layer FSPDN may correspond to the first power delivery network layer PDN1c in FIG. 13A.

Second ends of the unit capacitors UC (opposite to the first ends) may be electrically connected to the front side power delivery network layer FSPDN. The front side power delivery network layer FSPDN may be positioned on a front side (or an upper side, e.g., first surface 12a) of the dielectric layer 12 or the substrate. The front side power delivery network layer FSPDN may correspond to the second power delivery network layer PDN2c in FIG. 13A.

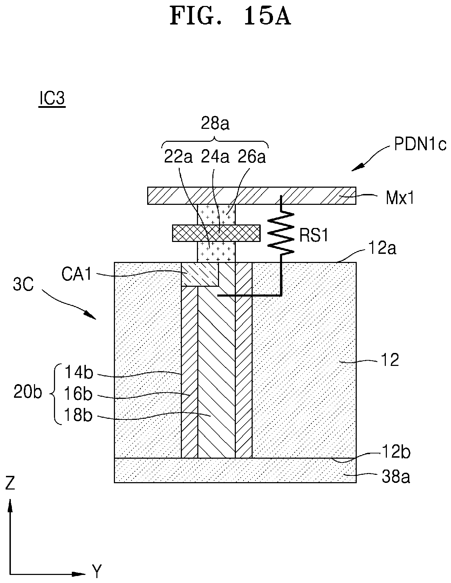

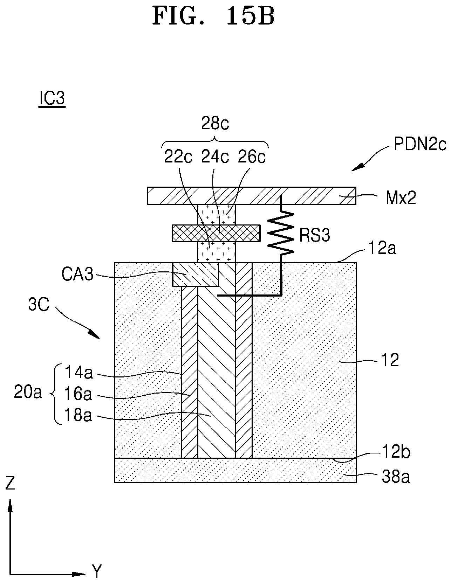

FIGS. 14A and 14B and FIGS. 15A and 15B are cross-sectional views of an integrated circuit device including the via capacitor shown in FIGS. 13A and 13B, according to some embodiments of the inventive concept.

Specifically, FIGS. 14A and 14B are cross-sectional views cut along the first direction (X direction) in FIGS. 13A and 13B, and FIGS. 15A and 15B are cross-sectional views cut along the second direction (Y direction) in FIGS. 13A and 13B. Unlike FIG. 13A, the integrated circuit device IC3 in FIGS. 14A and 14B is illustrated including four via electrode structures 20a to 20d for conveniences' sake.

The integrated circuit device IC3 may have the same structures as the integrated circuit devices IC1 in FIGS. 2A and 2B and FIGS. 3A and 3B, except for the configurations of the second power delivery network layer PDN2c. In FIGS. 14A and 14B and FIGS. 15A and 15B, the same or similar elements in FIGS. 2A and 2B and FIGS. 3A and 3B represent the same or similar configurations. In FIGS. 14A and 14B and FIGS. 15A and 15B, the same descriptions as those given with reference to FIGS. 2A and 2B and FIGS. 3A and 3B are briefly given or omitted.

The integrated circuit device IC3 may include a dielectric layer 12, a via capacitor 3C, a first power delivery network layer PDN1c, and a second power delivery network layer PDN2c. The via capacitor 3C may be arranged on (e.g., between) the first surface 12a and the second surface 12b. The via capacitor 3C may include first to fourth via electrode structures 20a to 20d spaced apart from each other in the first direction (X direction).

As shown in FIGS. 14A and 15A, the first power delivery network layer PDN1c may be arranged on the first surface 12a of the dielectric layer 12. The first power delivery network layer PDN1c may include the first active connection line 28a electrically connected to the second via electrode structure 20b through the first active contact CA1, and the first active wiring line Mx1 electrically connected to the first active connection line 28a.

The first active connection line 28a may include the first active connection wiring layer 24a and the first active connection via layers 22a and 26a. The first active connection line 28a and the first active wiring line Mx1 may be electrically connected through the active connection relationship CON1 in FIG. 13A. An electrical connection part from the second via electrode structure 20b to the first active wiring line Mx1 through the first active connection line 28a and the first active contact CA1 may be provided as a first resistance component RS1.

The first power delivery network layer PDN1c may include a second active connection line 28b electrically connected to the fourth via electrode structure 20d through a second active contact CA2, and a first active wiring line Mx1 electrically connected to the second active connection line 28b.

The second active connection line 28b may include a second active connection wiring layer 24b and second active connection via layers 22b and 26b. The second active connection line 28b and the first active wiring line Mx1 may be electrically connected through the active connection relationship CON1 in FIG. 13A. An electrical connection part from the fourth via electrode structure 20d to the first active wiring line Mx1 through the second active connection line 28b and the second active contact CA2 may be provided as a second resistance component RS2.

As shown in FIGS. 14B and 15B, the second power delivery network layer PDN2c may be provided on the first surface 12a of the dielectric layer 12. The second power delivery network layer PDN2c may include a third active connection line 28c electrically connected to the first via electrode structure 20a through a third active contact CA3, and the second active wiring line Mx2 electrically connected to the third active connection line 28c.

In some embodiments, as shown in FIG. 15B, a top surface of the third active contact CA3 may be coplanar with a top surface of the first via electrode structure 20a. In some embodiments, unlike FIG. 15B, the top surface of the third active contact CA3 may be higher than the top surface of the first via electrode structure 20a (e.g., farther than the top surface of the first via electrode structure 20a from the second surface 12b of the dielectric layer 12 in the third direction).

In some embodiments, as shown in FIG. 15B, the third active contact CA3 may not be aligned with the first via electrode structure 20a in the third direction (Z direction). In some embodiments, unlike FIG. 15B, the third active contact CA3 may be aligned with the first via electrode structure 20a in the third direction (Z direction). In some embodiments, as shown in FIG. 15B, an imaginary center line of the third active contact CA3 extending in the third direction may be shifted from an imaginary center line of the first via electrode structure 20a extending in the third direction in the second direction (Y direction).

The third active connection line 28c may include a third active connection wiring layer 24c and third active connection via layers 22c and 26c that electrically connect the third active connection wiring layer 24c with the second active wiring line Mx2. The third active connection line 28c and the second active wiring line Mx2 may be electrically connected through the active connection relationship CON1 in FIG. 13A. An electrical connection part from the first via electrode structure 20a to the second active wiring line Mx2 through the third active connection line 28c and the third active contact CA3 may be provided as a third resistance component RS3.

The second power delivery network layer PDN2c may also include a fourth active connection line 28d electrically connected to the third via electrode structure 20c through a fourth active contact CA4, and the second active wiring line Mx2 electrically connected to the fourth active connection line 28d. A fourth active contact CA4 may have the same structure as the third active contact CA3.

The fourth active connection line 28d may include a fourth active connection wiring layer 24d and fourth active connection via layers 22d and 26d that electrically connect the fourth active connection wiring layer 24d with the second active wiring line Mx2. The fourth active connection line 28d and the second active wiring line Mx2 may be electrically connected through the active connection relationship CON1 in FIG. 13A. An electrical connection part from the third via electrode structure 20c to the second active wiring line Mx2 through the fourth active connection line 28d and the fourth active contact CA4 may be provided as a fourth resistance component RS4.

In some embodiments, the second active wiring line Mx2 may extend in the first direction (X direction) over the first via electrode structure 20a and the third via electrode structure 20c. In some embodiments, the second active wiring line Mx2 may be spaced apart from the first via electrode structure 20a and the third via electrode structure 20c in the second direction (Y direction) over the first via electrode structure 20a and the third via electrode structure 20c and may extend in the first direction (X direction).

Thus, the via capacitor 3C may be implemented by using the first and second power delivery network layers PDN1c and PDN2c, and the capacitance of the via capacitor 3C may be easily controlled by using various variables in the integrated circuit device IC3. Accordingly, the degree of freedom in designing the integrated circuit device IC3 according to an embodiment may increase by reducing the area of the via capacitor 3C that is positioned in a vertical shape in the dielectric layer 12.

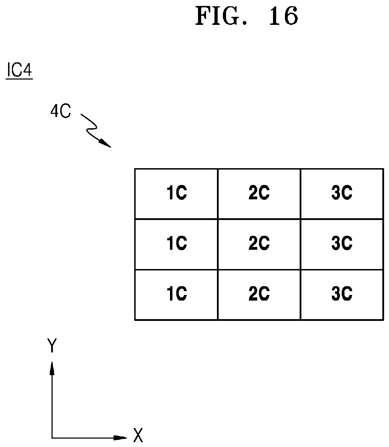

FIG. 16 is a layout of an integrated circuit device including a via capacitor according to some embodiments of the inventive concept.

Specifically, an integrated circuit device IC4 may include a via capacitor 4C. The via capacitor 4C may include first to third via capacitors 1C, 2C, and 3C that are arranged in a first direction (X direction) and a second direction (Y direction) in a shape of a matrix.

The first via capacitor 1C, the second via capacitor 2C, and the third via capacitor 3C may be sequentially arranged in the first direction (X direction). The first via capacitor 1C, the second via capacitor 2C, and the third via capacitor 3C may be sequentially arranged in a first row, a second row, and a third row, respectively, of the matrix.

Any one of the first to third via capacitors 1C, 2C, and 3C may be positioned in the second direction (Y direction). The first via capacitor 1C, the second via capacitor 2C, and the third via capacitor 3C may be positioned in a first column, a second column, and a third column of the matrix, respectively.

The first via capacitor 1C may include the via capacitor 1C shown in FIGS. 1A to 9B. The first via capacitor 1C may be implemented by using the first power delivery network layer PDN1a and the second power delivery network layer PDN2a shown in FIGS. 1A to 9B.

The second via capacitor 2C may include the via capacitor 2C shown in FIGS. 10A to 12B. The second via capacitor 2C may be implemented by using the first power delivery network layer PDN1b and the second power delivery network layer PDN2b shown in FIGS. 10A to 12B.

The third via capacitor 3C may include the via capacitor 3C shown in FIGS. 13A to 15B. The third via capacitor 3C may be implemented by using the first power delivery network layer PDN1c and the second power delivery network layer PDN2c shown in FIGS. 13A to 15B. Thus, the via capacitor 4C may be easily implemented by using the first to third via capacitors 1C, 2C, and 3C in the integrated circuit device IC4.

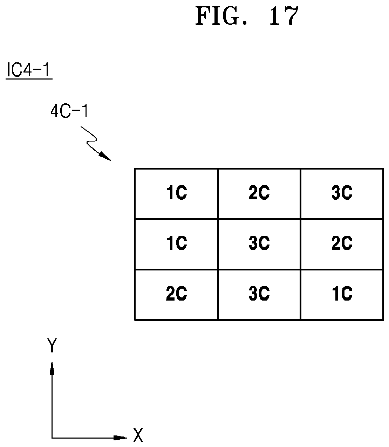

FIG. 17 is a layout of an integrated circuit device including a via capacitor according to some embodiments of the inventive concept.

Specifically, an integrated circuit device IC4-1 may include a via capacitor 4C-1. The via capacitor 4C-1 in FIG. 17 has the same structures as the via capacitor 4C shown in FIG. 16, except for the arrangement of the first to third via capacitors 1C, 2C, and 3C. In FIG. 17, the same descriptions as those given with reference to FIG. 16 are briefly given or omitted.

The integrated circuit device IC4-1 may include the first to third via capacitors 1C, 2C, and 3C that are arranged in the first direction (X direction) and the second direction (Y direction) in a shape of a matrix. The first to third via capacitors 1C, 2C, and 3C may be variously arranged in the first direction (X direction) and the second direction (Y direction).

For example, the first via capacitor 1C, the second via capacitor 2C, and the third via capacitor 3C may be sequentially arranged in a first row of the matrix. The first via capacitor 1C, the third via capacitor 3C, and the second via capacitor 2C may be sequentially arranged in a second row of the matrix. The second via capacitor 2C, the third via capacitor 3C, and the first via capacitor 1C may be sequentially arranged in a third row of the matrix.

The first via capacitor 1C and the second via capacitor 2C may be arranged in a first column of the matrix. The second via capacitor 2C and the third via capacitor 3C may be arranged in a second column of the matrix. The first via capacitor 1C, the second via capacitor 2C, and the third via capacitor 3C may be arranged in a third column of the matrix. Accordingly, the via capacitor 4C-1 may be easily implement by using the first to third via capacitors 1C, 2C, and 3C in the integrated circuit device IC4-1.

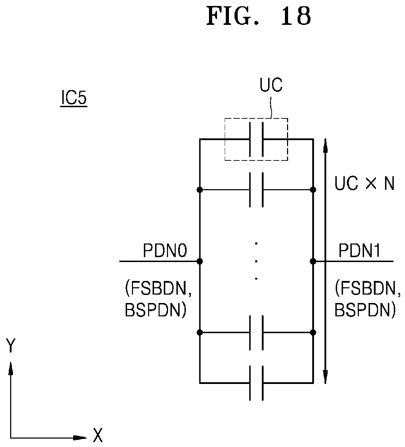

FIG. 18 is a schematic circuit diagram of an integrated circuit device according to some embodiments of the inventive concept.

Specifically, the integrated circuit device IC5 may include a unit capacitor UC. The unit capacitor UC may be any one of the via capacitors 1C, 2C, and 3C described in detail above. In the integrated circuit device IC5, N unit capacitors UC (N is a positive integer) may be arranged in the second direction (Y direction), as expressed by UC x N.

Unlike the previous integrated circuit devices IC1 to IC4, N unit capacitors UC (N is a positive integer) may be arranged in the second direction (Y direction) in the integrated circuit device IC5. In the integrated circuit device IC5, the unit capacitors UC may be electrically connected with one another in parallel in the second direction (Y direction). The unit capacitors UC may be arranged in such a configuration that capacitor electrodes (e.g., via electrode structures 20a and 20b) of the neighboring unit capacitors UC face each other in the first direction (X direction).

One end portion PDN0 of the unit capacitors UC may be electrically connected to one of the front side power delivery network layer (FSPDN) and the back side power delivery network layer (BSPDN), and the other end portion PDN1 of the unit capacitors UC may be electrically connected to the rest of the front side power delivery network layer (FSPDN) and the a back side power delivery network layer (BSPDN). The front power delivery network layer (FSPDN) may be arranged on a front side (or an upper side, e.g., first surface 12a) of a dielectric layer 12 or a substrate. The back side power delivery network layer (BSPDN) may be arranged on the rear surface (or the lower/back surface, e.g., second surface 12b) of the dielectric layer 12 or the substrate. Thus, the capacitance may be easily controlled by arranging the unit capacitor UC in the second direction (Y direction) in the integrated circuit device IC5.

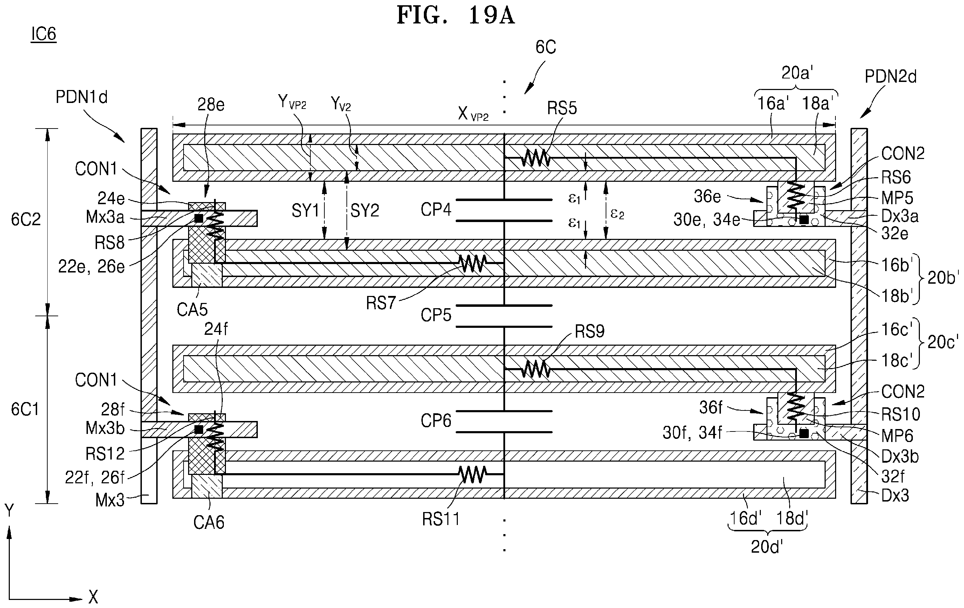

FIG. 19A is a layout of an integrated circuit device including a via capacitor according to some embodiments of the inventive concept.

Specifically, an integrated circuit device IC6 may have the same structures as the integrated circuit device IC1 shown in FIGS. 1A, 1B, 2A, 2B, 3A and 3B, except for the arrangement and shape of the via electrode structures 20a', 20b', 20c', and 20d'. In FIG. 19A, the same or similar elements in FIG. 1A, 1B, 2A, 2B, 3A, and 3B represent the same or similar configurations. In FIG. 19A, the same descriptions as those given with reference to FIGS. 1A, 1B, 2A, 2B, 3A, and 3B are briefly given or omitted.

The integrated circuit device IC6 may include a dielectric layer 12 in FIGS. 2A and 2B, a via capacitor 6C, a first power delivery network layer PDN1d, and a second power delivery network layer PDN2d. In FIG. 19A, the integrated circuit device IC6 is illustrated including two via capacitors 6C1 and 6C2, for conveniences' sake. A plurality of via capacitors may be arranged in the second direction (Y direction) in the integrated circuit device IC6.

The via capacitor 6C may be implemented by using the first power delivery network layer PDN1d and the second power delivery network layer PDN2d in the integrated circuit device IC6. The via capacitor 6C may be positioned in at least one of a cell region and a peripheral circuit region of the integrated circuit device IC6.

The via capacitor 6C may include via electrode structures 20a', 20b', 20c', and 20d' spaced apart from each other in the second direction (Y direction). The via electrode structures 20a', 20b', 20c', and 20d' are referred to as first via electrode structure 20a', second via electrode structure 20b', third via electrode structure 20c', and fourth via electrode structure 20d', respectively. In FIG. 19A, four via electrode structures 20a', 20b', 20c', and 20d') are illustrated for conveniences' sake, however, any additional via electrode structures may be further provided in the second direction (Y direction).

The first via electrode structure 20a' may include a first via electrode 18a' and a first via insulating layer 16a' extending around (e.g., surrounding) the first via electrode 18a' in a plan view. The second via electrode structure 20b' may include a second via electrode 18b' and a second via insulating layer 16b' extending around (e.g., surrounding) the second via electrode 18b' in a plan view.

The third via electrode structure 20c' may include a third via electrode 18c' and a third via insulating layer 16c' extending around (e.g., surrounding) the third via electrode 18c' in a plan view. The fourth via electrode structure 20d' may include a fourth via electrode 18d' and a fourth via insulating layer 16d' extending around (e.g., surrounding) the fourth via electrode 18d' in a plan view.

The first to fourth via electrode structures 20a', 20b', 20c', and 20d' may be arranged at equal intervals in the second direction (Y direction) The first to fourth via electrode structures 20a', 20b', 20c', and 20d' may be arranged to face each other in the second direction (Y direction). The first to fourth via electrodes 18a', 18b', 18c', and 18d' may include a metal layer, for example, a copper (Cu) layer, an aluminum (Al) layer, a tungsten (W) layer, but are not limited thereto. The first to fourth via insulating layers 16a', 16b', 16c', and 16d' may include a silicon nitride layer and/or a silicon oxide layer, but are not limited thereto.

A fourth capacitor component CP4 may be positioned between the first via electrode structure 20a' and the second via electrode structure 20b' in the second direction (Y direction). A fifth capacitor component CP5 may be positioned between the second via electrode structure 20b' and the third via electrode structure 20c' in the second direction (Y direction). A sixth capacitor component CP6 may be positioned between the third via electrode structure 20c' and the fourth via electrode structure 20d' in the second direction (Y direction).

The first power delivery network layer PDN1d may include a fifth active connection line 28e electrically connected to the second via electrode structure 20b' through a fifth active contact CA5 and a first additional active connection line Mx3a and a third active wiring line Mx3 that are electrically connected to the fifth active connection line 28e.

The fifth active connection line 28e may be electrically connected to the first additional active connection line Mx3a and the third active wiring line Mx3 through the active connection relationship CON1. An electrical connection part from the second via electrode structure 20b' to the fifth active connection line 28e (e.g., through the fifth active contact CA5) may be provided as a seventh resistance component RS7 and an eighth resistance component RS8.

The first additional active connection line Mx3a may extend in the first direction (X direction). The third active wiring line Mx3 may extend in the second direction (Y direction). The fifth active contact CA5 may be a contact that is positioned in an active region of the dielectric layer 12 in FIGS. 2A and 2B. The fifth active connection line 28e may include fifth active connection via layers 22e and 26e electrically connecting the fifth active connection wiring layer 24e with first additional active connection line Mx3a.

The first power delivery network layer PDN1d may include a sixth active connection line 28f electrically connected to the fourth via electrode structure 20d' through a sixth active contact CA6, and a second additional active connection line Mx3b and the third active wiring line Mx3 that are electrically connected to the sixth active connection line 28f. The sixth active connection line 28f may be electrically connected to the second additional active connection line Mx3b and the third active wiring line Mx3 through the active connection relationship CON1. An electrical connection part from the fourth via electrode structure 20d' to the sixth active connection line 28f (e.g., through the sixth active contact CA6) may be provided as an eleventh resistance component RS 11 and a twelfth resistance element RS 12.

The second additional active connection line Mx3b may extend in the first direction (X direction). The sixth active contact CA6 may be a contact that is positioned in an active region of the dielectric layer 12 in FIGS. 2A and 2B. The sixth active connection line 28f may include sixth active connection via layers 22f and 26f that electrically connect the sixth active connection wiring layer 24f and the second additional active connection line Mx3b.

The second power delivery network layer PDN2d may include a fifth pad connection line 36e electrically connected to the first via electrode structure 20a' through a fifth conductive pad MP5 and a first additional pad connection line Dx3a and a third pad wiring line Dx3 that are electrically connected to the fifth pad connection line 36e.

The fifth pad connection line 36e may be electrically connected to the first additional pad connection line Dx3a and the third pad wiring line Dx3 through the pad connection relationship CON2. An electrical connection part from the first via electrode structure 20a' to the fifth pad connection line 36e through the fifth conductive pad MP5 may be provided as a fifth resistance component RS5 and a sixth resistance element RS6.

The first additional pad connection line Dx3a may extend in the first direction (X direction). The third pad wiring line Dx3 may extend in the second direction (Y direction). The fifth conductive pad MP5 may be a pad positioned in an active region or an inactive region. The fifth pad connection line 36e may include a pad connection wiring layer 32e and pad connection via layers 30e and 34e, as described above.

The second power delivery network layer PDN2d may also include a sixth pad connection line 36f electrically connected to the third via electrode structure 20c' through a sixth conductive pad MP6 and a second additional pad connection line Dx3b and the third pad wiring line Dx3 that are electrically connected to the sixth pad connection line 36f.

The sixth pad connection line 36f may be electrically connected to the second additional pad connection line Dx3b and the third pad wiring line Dx3 through the pad connection relationship CON2. An electrical connection part from the third via electrode structure 20c' to the sixth pad connection line 36f through the sixth conductive pad MP6 may be provided as a ninth resistance component RS9 and a tenth resistance element RS10.

The second additional pad connection line Dx3b may extend in the first direction (X direction). The sixth conductive pad MP6 may be a pad positioned in an active region or an inactive region. The sixth pad connection line 36f may include a pad connection wiring layer 32f and pad connection via layers 30f and 34f, as described above.

In some embodiments, the power delivery network layers PDN1d and PDN2d may function as the first power delivery network layer PDN1d and as the second power delivery network layer PDN2d. However, in other embodiments, the power delivery network layers PDN1d and PDN2d may function as the second power delivery network layer PDN2d and the first power delivery network layer PDN1d.

Herein, the arrangement of the first to fourth via electrode structures 20a', 20b', 20c', and 20d' of the via capacitor 6C is described in more detail.

The first to fourth via electrode structures 20a', 20b', 20c', and 20d' may have a fourth length Xvp2 in the first direction (X direction) and a fifth length Yvp2 in the second direction (Y direction). The first to fourth via electrodes 18a', 18b', 18c', and 18d' may have a sixth length Yv2 in the second direction (Y direction). In some embodiments, the fourth length Xvp2, the fifth length Yvp2, and the sixth length Yv2 may be in a range of several nanometers to tens of nanometers.

The first via electrode structure 20a' and the second via electrode structure 20b' may be spaced apart by a third gap distance SY1 in the second direction (Y direction), and more particularly, the first via insulating layer 16a' and the second via insulating layer 16b' may be spaced apart by the third gap distance SY1 in the second direction. For example, the shortest distance between the first via insulating layer 16a' and the second via insulating layer 16b' in the second direction may be the third gap distance SY1. The first via electrode 18a' and the second via electrode 18b' may be spaced apart by a fourth gap distance SY2 in the second direction (Y direction). For example, the shortest distance between the first via electrode 18a' and the second via electrode 18b' in the second direction may be the fourth gap distance SY2. In some embodiments, the fourth gap distance SY2 may be greater than the third gap distance SY1. The third gap distance SY1 and the fourth gap distance SY2 may be in a range of several nanometers to tens of nanometers.

The dielectric layer 12 in FIGS. 2A and 2B, which is positioned between the first via electrode structure 20a' and the second via electrode structure 20b' in the second direction (Y direction), may have the relative dielectric constant of ε2. The first via insulating layer 16a', which is positioned between the first via electrode 18a' and the dielectric layer 12 in FIGS. 2A and 2B in the second direction (Y direction), may have the relative dielectric constant of ε1. The second via insulating layer 16b', which is positioned between the second via electrode 18b' and the dielectric layer 12 in FIGS. 2A and 2B in the second direction (Y direction), may have the relative dielectric constant of ε1. In some embodiments, the relative dielectric constant ε2 may be greater than the relative dielectric constant ε1.

Accordingly, the via capacitor 6C may be implemented by using the first and second power delivery network layers PDN1d and PDN2d in the integrated circuit device IC6. In addition, the integrated circuit device IC6 may easily control the capacitance of the via capacitor 6C by adjusting the fourth length Xvp2, the fifth length Yvp2, the sixth length Yv2, the third gap distance SY1, the fourth gap distance SY2, and the relative dielectric constants ε1 and ε2. Accordingly, the degree of freedom in designing the integrated circuit device IC6 according to an embodiment may increase by reducing the area of the via capacitor 6C.

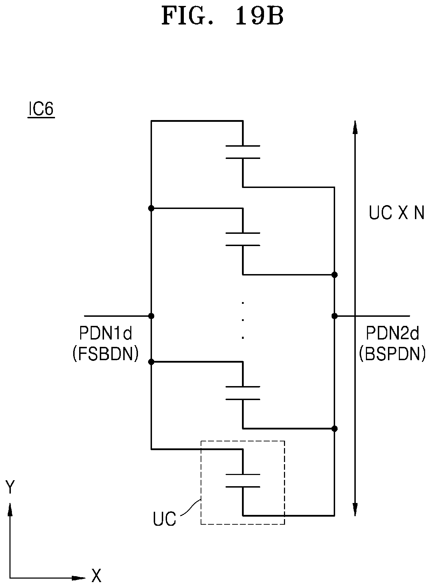

FIG. 19B is a schematic circuit diagram of the integrated circuit device in FIG. 19A.

Specifically, the integrated circuit device IC6 may include a unit capacitor UC. The unit capacitor UC may include the via capacitor 6C shown in FIG. 19A. The unit capacitor UC may be arranged between the first to fourth via electrode structures 20a', 20b', 20c', and 20d' in the second direction (Y direction). The unit capacitor UC may be positioned in such a configuration that capacitor electrodes (e.g., first to fourth via electrode structures 20a', 20b', 20c', and 20d') of the neighboring unit capacitors face each other in the second direction (Y direction).

In the integrated circuit device IC6, N unit capacitors UC (N is a positive integer) may be arranged in the second direction (Y direction), as expressed by UC x N. In the integrated circuit device IC6, the unit capacitors UC may be electrically connected with one another in parallel in the second direction (Y direction).

First ends of the unit capacitors UC may be electrically connected to the first power delivery network layer PDN1d. The first power delivery network layer PDN1d may be electrically connected to a front side power delivery network layer FSPDN.

Second ends opposite to the first ends of the unit capacitors UC may be electrically connected to the second power delivery network layer PDN2d. The second power delivery network layer PDN2d may be electrically connected to the back side power delivery network layer BSPDN.

The front side power delivery network layer FSPDN may be arranged on a front side (or an upper side, e.g., the first surface 12a) of the dielectric layer 12 or the substrate. The back side power delivery network layer BSPDN may be arranged on a back side (or a back/lower side, e.g., the second surface 12b) of the dielectric layer 12 or the substrate. Thus, the integrated circuit device IC6 may easily control the capacitance just by arranging the unit capacitors UC in the second direction (Y direction).

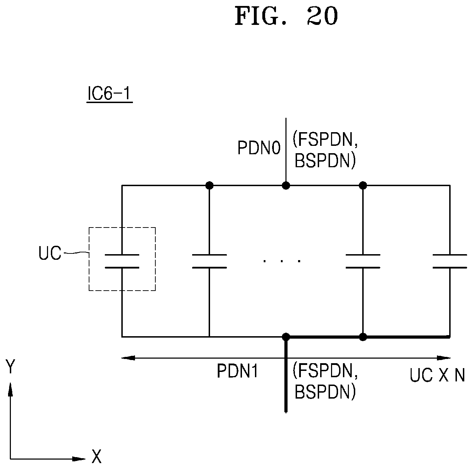

FIG. 20 is a schematic circuit diagram of an integrated circuit device according to some embodiments of the inventive concept.

Specifically, an integrated circuit device IC6-1 may have substantially the same structures as the integrated circuit device IC6 shown in FIGS. 19A and 19B, except that the unit capacitors UC are arranged in the first direction (X direction). The integrated circuit device IC6-1 may include a unit capacitor UC. The electrodes (e.g., first to fourth via electrode structures 20a', 20b', 20c', and 20d') of the unit capacitors UC may be arranged to face each other in the second direction (Y direction), as is described with reference to FIGS. 19A and 19B.

In the integrated circuit device IC6-1, N unit capacitors UC (N is a positive integer) may be arranged in the first direction (X direction), as expressed by UC x N. In the integrated circuit device IC6-1, the unit capacitors UC may be electrically connected with one another in parallel in the first direction (X direction). First ends of the unit capacitors UC may be electrically connected to the first power delivery network layer PDN0. The first power delivery network layer PDN0 may be electrically connected to one of the front side power delivery network layer FSPDN and the back side power delivery network layer BSPDN.

As described above, the front side power delivery network layer FSPDN may be arranged on a front side (or an upper side, e.g., the first surface 12a) of the dielectric layer 12 or the substrate. The back side power delivery network layer BSPDN may be arranged on a back side (or the back/lower side, e.g., the second surface 12b) of the dielectric layer 12 or the substrate. Thus, the capacitance may be easily controlled just by arranging the unit capacitors UC such that the capacitor electrodes of the unit capacitors UC face each other in the second direction (Y direction) and the unit capacitors UC are arranged in the in the first direction (X direction) in the integrated circuit device IC6-1.

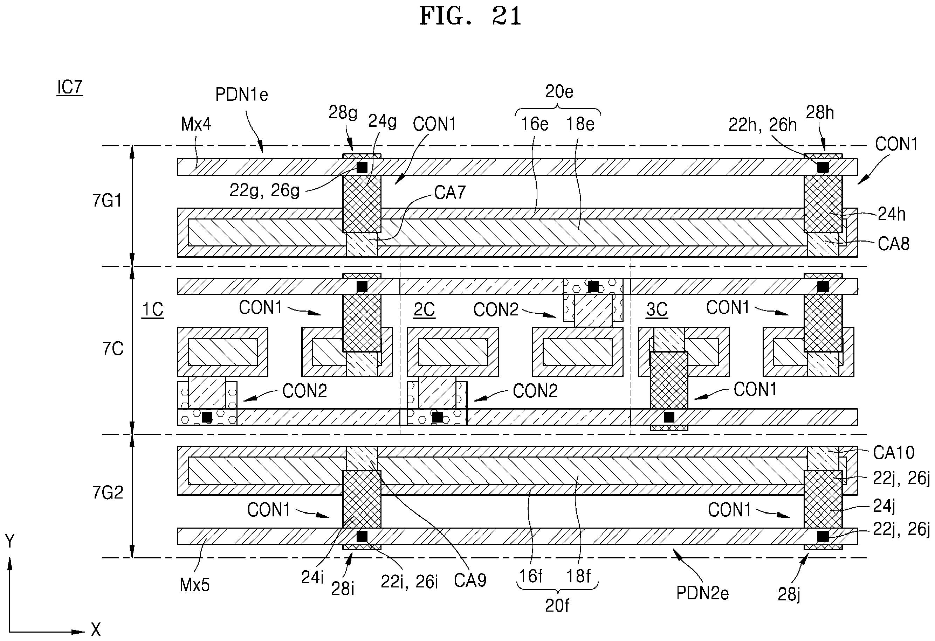

FIG. 21 is a layout of an integrated circuit device including a via capacitor according to some embodiments of the inventive concept.

Specifically, an integrated circuit device IC7 according to some embodiments may have substantially the same structures as the integrated circuit devices IC1, IC2, and IC3 shown in FIGS. 1A to 15B, except that guard ring structures 7G1 and 7G2 are further included. In FIG. 21, the same or similar elements in FIGS 1A to 15B represent the same or similar configurations. In FIG. 21, the same descriptions as those given with reference to FIGS 1A to 15B are briefly given or omitted.

The integrated circuit device IC7 may include a via capacitor 7C and guard ring structures 7G1 and 7G2. The guard ring structures 7G1 and 7G2 may protect internal circuits such as transistors or active regions in the integrated circuit device IC7. In some embodiments, the via capacitor 7C may include the via capacitor 1C described with reference to FIGS. 1A to 9B, the via capacitor 2C described with reference to FIGS. 10A to 12B, and/or the via capacitor 3C described with reference to FIGS. 13A to 15B. In some embodiments, the via capacitor 7C may include at least one of the first via capacitor 1C, the second via capacitor 2C, and the third via capacitor 3C.

The via capacitor 1C may be electrically connected to the power delivery network layers PDN1a and PDN2a in FIGS. 1A to 9B through the active connection relationship CON1 and the pad connection relationship CON2. The via capacitor 2C may be electrically connected to the power delivery network layers PDN1b and PDN2b in FIGS. 10A to 12B through the pad connection relationship CON2. The via capacitor 3C may be electrically connected to the power delivery network layers PDN1c and PDN2c in FIGS. 13A to 15B through the active connection relationship CON1.

A plurality of guard ring structures 7G1 and 7G2 may be provided in the integrated circuit device IC7 such that the guard ring structures 7G1 and 7G2 are spaced apart from the via capacitor 7C, that is, from the power delivery network layers PDN1a, PDN2a, PDN1b, PDN2b, PDN1c, and PDN2c shown in FIGS. 1A to 15B. The guard ring structures 7G1 and 7G2 may be referred to as first guard ring structure 7G1 and second guard ring structure 7G2.

The first guard ring structure 7G1 may include a first additional via electrode structure 20e. The first additional via electrode structure 20e may include a member that is arranged on (e.g., between) the first surface 12a in FIGS. 2A to 3B and the second surface 12b in FIGS. 2A to 3B of the dielectric layer 12 in FIGS. 2A to 3B. The first additional via electrode structure 20e may include a first additional via electrode 18e and a first additional via insulating layer 16e extending around (e.g., surrounding) the first additional via electrode 18e in a plan view.

A third power delivery network layer PDN1e may be electrically connected to the first additional via electrode structure 20e. The third power delivery network layer PDN1e may include a seventh active connection line 28g electrically connected to the first additional via electrode structure 20e through a seventh active contact CA7 and a fourth active wiring line Mx4 electrically that is electrically connected to the seventh active connection line 28g. The seventh active connection line 28g may be electrically connected to the fourth active wiring line Mx4 through the active connection relationship CON1. The fourth active wiring line Mx4 may be electrically connected to ground and function as a ground line.

The fourth active wiring line Mx4 may extend in the first direction (X direction). The seventh active connection line 28g may include a seventh active connection wiring layer 24g extending in the second direction and seventh active connection via layers 22g and 26g electrically connecting the seventh active connection wiring layer 24g with the fourth active wiring line Mx4.

The third power delivery network layer PDN1e may also include an eighth active connection line 28h electrically connected to the first additional via electrode structure 20e through an eighth active contact CA8 and the fourth active wiring line Mx4 electrically connected to the eighth active connection line 28h. The eighth active connection line 28h may be electrically connected to the fourth active wiring line Mx4 through the active connection relationship CON1.

The eighth active connection line 28h may include an eighth active connection wiring layer 24h extending in the second direction and eighth active connection via layers 22h and 26h electrically connecting the eighth active connection wiring layer 24h with the fourth active wiring line Mx4.

FIG. 21 shows that the active wiring line Mx4 is electrically connected to the first additional via electrode structure 20e through the active connection relationship CON1 for conveniences' sake, however, the pad wiring line may also be electrically connected to the first additional via electrode structure 20e through the pad connection relationship CON2.

The second guard ring structure 7G2 may include a second additional via electrode structure 20f. The second additional via electrode structure 20f may include a member that is arranged between the first surface 12a in FIGS. 2A, 2B, 3A, and 3B and the second surface 12b in FIGS. 2A, 2B, 3A, and 3B of the dielectric layer 12 in FIGS. 2A, 2B, 3A, and 3B. The second additional via electrode structure 20f may include a second additional via electrode 18f and a second additional via insulating layer 16f extending around (e.g., surrounding) the second additional via electrode 18f in a plan view.

A fourth power delivery network layer PDN2e may be electrically connected to the second additional via electrode structure 20f. The fourth power delivery network layer PDN2e may include a ninth active connection line 28i electrically connected to the second additional via electrode structure 20f through a ninth active contact CA9 and a fifth active wiring line Mx5 electrically connected to the ninth active connection line 28i. The ninth active connection line 28i may be electrically connected to the fifth active wiring line Mx5 through the active connection relationship CON1. The fifth active wiring line Mx5 may be electrically connected to ground and function as a ground line.

The fifth active wiring line Mx5 may extend in the first direction (X direction). The ninth active connection line 28i may include a ninth active connection wiring layer 24i extending in the second direction and ninth active connection via layers 22i and 26i electrically connecting the ninth active connection wiring layer 24i with the fifth active wiring line Mx5.

The fourth power delivery network layer PDN2e may also include a tenth active connection line 28j electrically connected to the second additional via electrode structure 20f through a tenth active contact CA10 and the fifth active wiring line Mx5 electrically connected to the tenth active connection line 28j. The tenth active connection line 28j may be electrically connected to the fifth active wiring line Mx5 through the active connection relationship CON1.

The tenth active connection line 28j may include a tenth active connection wiring layer 24j extending in the second direction and tenth active connection via layers 22j and 26j electrically connecting the tenth active connection wiring layer 24j with the fifth active wiring line Mx5.

FIG. 21 shows that the active wiring line Mx5 is electrically connected to the second additional via electrode structure 20f through the active connection relationship CON1 for conveniences' sake, however, the pad wiring line may also be electrically connected to the second additional via electrode structure 20f through the pad connection relationship CON2.

In manufacturing the integrated circuit device IC7, the guard ring structures 7G1 and 7G2 may be formed when forming the via capacitor 7C. In addition, third and fourth power delivery network layers PDN1e and PDN2e may be formed together with the power delivery network layers PDN1a, PDN2a, PDN1b, PDN2b, PDN1c, and PDN2c in FIGS. 1A to 15B that are used for the via capacitor 7C in manufacturing the integrated circuit device IC7.

Accordingly, the manufacturing process in the integrated circuit device IC7 may simplify and the degree of freedom in designing integrated circuit device IC7 increase by reducing the area of the via capacitor 7C and the guard ring structures 7G1 and 7G2.

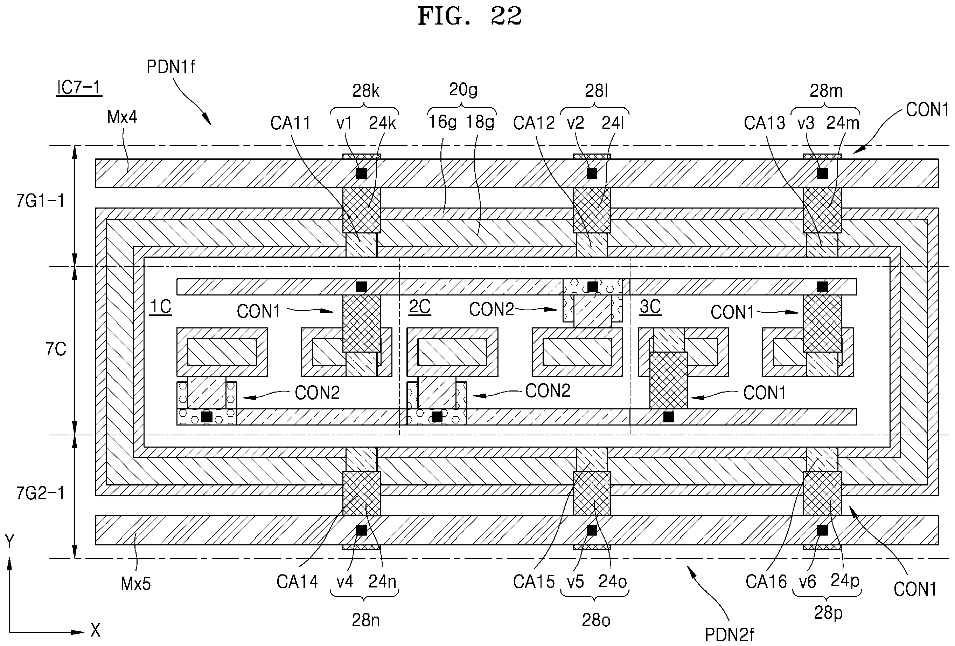

FIG. 22 is a layout of an integrated circuit device including a via capacitor according to some embodiments of the inventive concept.

Specifically, an integrated circuit device IC7-1 may have substantially the same structure as the integrated circuit device IC7 shown in FIG. 21, except that a third additional via electrode structure 20g extends around (e.g., surrounds) the via capacitor 7C in a plan view. In FIG. 22, the same or similar elements in FIG. 21 represent the same or similar configurations. In FIG. 22, the same descriptions as those given with respect to FIG. 21 are briefly given or omitted.

The integrated circuit device IC7-1 may include the via capacitor 7C and guard ring structures 7G1-1 and 7G2-1. The guard ring structures 7G1-1 and 7G2-1 may protect internal circuits such as transistors in the integrated circuit device IC7-1.

In some embodiments, the via capacitor 7C may include the via capacitor 1C described with respect to FIGS. 1A to 9B, the via capacitor 2C described with respect to FIGS. 10A to 12B, and/or the via capacitor 3C described with respect to FIGS. 13A to 15B. In some embodiments, the via capacitor 7C may include at least one of the first via capacitor 1C, the second via capacitor 2C, and the third via capacitor 3C.

The via capacitors 1C, 2C, and 3C may be electrically connected to the power delivery network layers PDN1a, PDN2a, PDN1b, PDN2b, PDN1c, and PDN2c shown in FIGS. 1A to 15B through the active connection relationship CON1 and the pad connection relationship CON2.

A plurality of guard ring structures 7G1-1 and 7G2-1 may be provided in the integrated circuit device IC7-1 such that the guard ring structures 7G1-1 and 7G2-1 are spaced apart from the via capacitor 7C, that is, from any one of the power delivery network layers PDN1a, PDN2a, PDN1b, PDN2b, PDN1c, and PDN2c shown in FIGS. 1A to 15B. The guard ring structures 7G1-1 and 7G2-1 may be referred to as first guard ring structure 7G1-1 and second guard ring structure 7G2-1.

The guard ring structures 7G1-1 and 7G2-1 may include a third additional via electrode structure 20g extending around (e.g., surrounding) the via capacitor 7C in a plan view. The third additional via electrode structure 20g may include a third additional via electrode 18g and a third additional via insulating layer 16g extending around (e.g., surrounding) the third additional via electrode 18g in a plan view.

A third power delivery network layer PDNlf may be electrically connected to the third additional via electrode structure 20g. The third power delivery network layer PDNlf may include eleventh to thirteenth active connection lines 28k, 28l, and 28m electrically connected to the third additional via electrode structure 20g through eleventh to thirteenth active contacts CA11, CA12, and CA13, respectively and a fourth active wiring line MX4 electrically connected to the eleventh to thirteenth active connection lines 28k, 28l, and 28m. The eleventh to thirteenth active connection lines 28k, 28l, and 28m may be electrically connected to the fourth active wiring line Mx4 through the active connection relationship CON1. The fourth active wiring line Mx4 may be electrically connected to ground and function as a ground line.

The fourth active wiring line Mx4 may extend in the first direction (X direction). The eleventh to thirteenth active connection lines 28k, 28l, and 28m may include eleventh to thirteenth active connection wiring layers 24k, 24l, and 24m, respectively, extending in the second direction, and eleventh to thirteenth active connection via layers v1, v2, and v3 electrically connecting the eleventh to thirteenth active connection wiring layers 24k, 24l, and 24m with the fourth active wiring lines Mx4, respectively.

FIG. 22 shows that the fourth active wiring line Mx4 is electrically connected to the third additional via electrode structure 20g through the active connection relationship CON1 for conveniences' sake, however, the pad wiring line may also be electrically connected to the third additional via electrode structure 20g through the pad connection relationship CON2.

A fourth power delivery network layer PDN2f may be electrically connected to the third additional via electrode structure 20g. The fourth power delivery network layer PDN2f may include fourteenth to sixteenth active connection lines 28n, 28o, and 28p electrically connected to the third additional via electrode structure 20g through fourteenth to sixteenth active contacts CA14, CA15, and CA16, respectively and a fifth active line Mx5 electrically connected to the fourteenth to sixteenth active connection lines 28n, 28o, and 28p. The fourteenth to sixteenth active connection lines 28n, 28o, and 28p may be electrically connected to the fifth active wiring line Mx5 through the active connection relationship CON1. The fifth active wiring line Mx5 may be electrically connected to ground and function as a ground line.

The fifth active wiring line Mx5 may extend in the first direction (X direction). The fourteenth to sixteenth active connection lines 28n, 28o, and 28p may include fourteenth to sixteenth active connection wiring layers 24n, 24o, and 24p, respectively, extending in the second direction, and fourteenth to sixteenth to active connection via layers v4, v5, and v6 electrically connecting the fourteenth to sixteenth active connection wiring layers 24n, 24o, and 24p with the fifth active wiring lines Mx5, respectively.

FIG. 22 shows that the fifth active wiring line Mx5 is electrically connected to the third additional via electrode structure 20g through the active connection relationship CON1 for conveniences' sake, however, the pad wiring line may also be electrically connected to the third additional via electrode structure 20g through the pad connection relationship CON2.

In manufacturing the integrated circuit device IC7-1, the guard ring structures 7G1-1 and 7G2-1 may be formed when forming the via capacitor 7C. Accordingly, the manufacturing process in the integrated circuit device IC7-1 according to some embodiments may simplify and the degree of freedom in designing the device may increase by reducing the area of the via capacitor 7C and the guard ring structures 7G1-1 and 7G2-1.

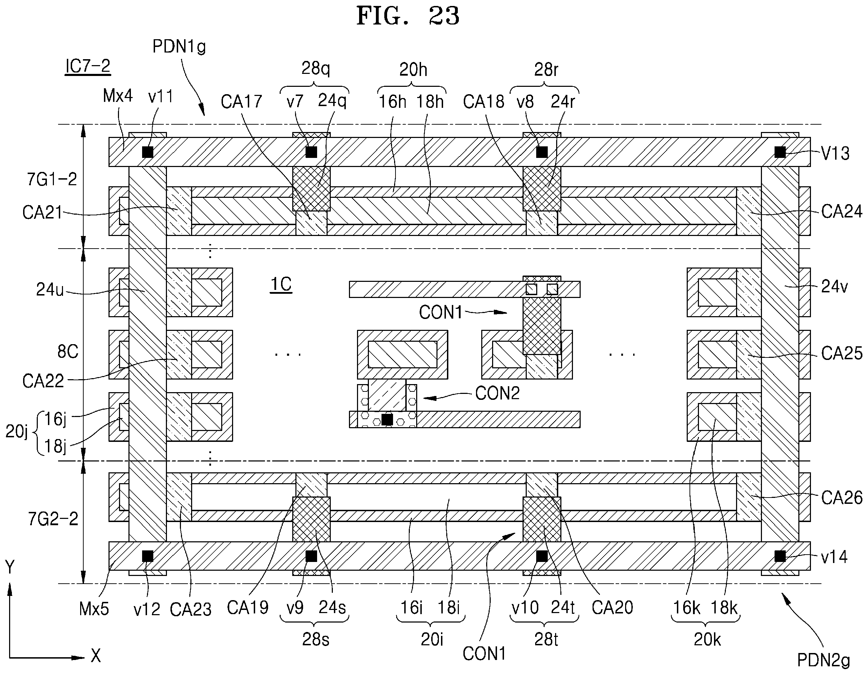

FIG. 23 is a layout of an integrated circuit device including a via capacitor according to some embodiments of the inventive concept.

Specifically, an integrated circuit device IC7-2 may have substantially the same structures as the integrated circuit devices IC7 and IC7-1 shown in FIGS. 21 and 22, except for the configurations of the via capacitor 8C and the connection of the fourth and fifth additional via electrode structures 20h and 20i with the active connection wiring layers 24u and 24v. In FIG. 23, the same or similar elements in FIGS. 21 and 22 represent the same or similar configurations. In FIG. 23, the same descriptions as those given with respect to FIGS. 21 and 22 are briefly given or omitted.

An integrated circuit device IC7-2 according to some embodiments may include a via capacitor 8C and the guard ring structures 7G1-2 and 7G2-2. The guard ring structures 7G2-1 and 7G2-2 may protect internal circuits such as transistors in the integrated circuit device IC7-2.

The via capacitor 8C may include the first via capacitor 1C described with respect to FIGS. 1A to 9B. The via capacitor 8C may be electrically connected to the power delivery network layers PDN1a and PDN2a shown in FIGS. 1A to 9B through the active connection relationship CON1 and the pad connection relationship CON2. In some embodiments, the via capacitor 8C may include at least one of the via capacitor 1C described with respect to FIGS. 1A to 9B, the via capacitor 2C described with respect to FIGS. 10A to 12B, and the via capacitor 3C described with respect to FIGS. 13A to 15B.

A plurality of guard ring structures 7G1-2 and 7G2-2 may be provided in the integrated circuit device IC7-2 such that the guard ring structures 7G1-2 and 7G2-2 are spaced apart from the via capacitor 8C, that is, from the power delivery network layers PDN1a and PDN2a shown in FIGS. 1A to 9B. The guard ring structures 7G1-2 and 7G2-2 may be referred to as first guard ring structure 7G1-2 and second guard ring structure 7G2-2.

The first guard ring structure 7G1-2 may include a fourth additional via electrode structure 20h. The fourth additional via electrode structure 20h may include a fourth additional via electrode 18h and a fourth additional via insulating layer 16h extending around (e.g., surrounding) the fourth additional via electrode 18h in a plan view.

A third power delivery network layer PDN1g may be electrically connected to the fourth additional via electrode structure 20h. The third power delivery network layer PDN1g may include seventeenth and eighteenth active connection lines 28q and 28r electrically connected to the fourth additional via electrode structure 20h through seventeenth and eighteenth active contacts CA17 and CA18, respectively and a fourth active wiring line Mx4 electrically connected to the seventeenth and eighteenth active connection lines 28q and 28r. The seventeenth and eighteenth active connection lines 28q and 28r may be electrically connected to the fourth active wiring line Mx4 through the active connection relationship CON1. The fourth active wiring line Mx4 may be electrically connected to ground and function as a ground line.

The fourth active wiring line Mx4 may extend in the first direction (X direction). The seventeenth and eighteenth active connection lines 28q and 28r may include seventeenth and eighteenth active connection wiring layers 24q and 24r, respectively, extending in the second direction, and seventeenth and eighteenth active connection via layers v7 and v8 electrically connecting the seventeenth and eighteenth active connection wiring layers 24q and 24r with the fourth active wiring line Mx4, respectively.

FIG. 23 shows that the fourth active wiring line Mx4 is electrically connected to the fourth additional via electrode structure 20h through the active connection relationship CON1 for conveniences' sake, however, the pad wiring line may also be electrically connected to the fourth additional via electrode structure 20g through the pad connection relationship CON2.

The second guard ring structure 7G2-2 may include a fifth additional via electrode structure 20i. The fifth additional via electrode structure 20i may include a fifth additional via electrode 18i and a fifth additional via insulating layer 16i surrounding the fifth additional via electrode 18i in a plan view.

A fourth power delivery network layer PDN2g may be electrically connected to the fifth additional via electrode structure 20i. The fourth power delivery network layer PDN2g may include nineteenth and twentieth active connection lines 28s and 28t electrically connected to the fifth additional via electrode structure 20i through nineteenth and twentieth active contacts CA19 and CA20, respectively and a fifth active wiring line Mx5 electrically connected to the nineteenth and twentieth active connection lines 28s and 28t. The nineteenth and twentieth active connection lines 28s and 28t may be electrically connected to the fifth active wiring line Mx5 through the active connection relationship CON1. The fifth active wiring line Mx5 may be electrically connected to ground and function as a ground line.

The fifth active wiring line Mx5 may extend in the first direction (X direction). The nineteenth and twentieth active connection lines 28s and 28t may include nineteenth and twentieth active connection wiring layers 24s and 24t, respectively, extending in the second direction and nineteenth and twentieth active connection via layers v9 and v10 electrically connecting the nineteenth and twentieth active connection wiring layers 24s and 24t with the fifth active wiring line Mx5, respectively.

FIG. 23 shows that the fifth active wiring line Mx5 is electrically connected to the fifth additional via electrode structure 20i through the active connection relationship CON1 for conveniences' sake, however, the pad wiring line may also be electrically connected to the fifth additional via electrode structure 20i through the pad connection relationship CON2.

The integrated circuit device IC7-2 may further include sixth and seventh additional via electrode structures 20j and 20k in a region of the via capacitor 8C. The sixth and seventh additional via electrode structures 20j and 20k may be spaced apart in the first direction (X direction). The sixth and seventh additional via electrode structures 20j and 20k may include sixth and seventh additional via electrodes 18j and 18k, respectively and the sixth and seventh additional via insulating layers 16j and 16k extending around (e.g., surrounding) the sixth and seventh additional via electrodes 18j and 18k in a plan view, respectively.

The integrated circuit device IC7-2 may include a twenty-first (21st) active connection wiring layer 24u electrically connecting the fourth additional via electrode structure 20h, the fifth additional via electrode structure 20i, and the sixth additional via electrode structure 20j. The 21st active connection wiring layer 24u may extend in the second direction (Y direction).

The 21st active connection wiring layer 24u may be electrically connected to the fourth additional via electrode structure 20h and the fifth additional via electrode structure 20i through the 21st and 23rd active contacts CA21 and CA23, respectively. The 21st active connection wiring layer 24u may be electrically connected to the sixth additional via electrode structure 20j through the 22nd active contact CA22. The fourth and fifth additional via electrode structures 20h and 20i may be electrically connected to the fourth and fifth active wiring lines Mx4 and Mx5 through the 21st and 22nd active connection via layers v11 and v12, respectively.

The integrated circuit device IC7-2 may include a 22nd active connection wiring layer 24v electrically connecting the fourth additional via electrode structure 20h, the fifth additional via electrode structure 20i, and the seventh additional via electrode structure 20k. The 22nd active connection wiring layer 24v may extend in the second direction (Y direction).

The 22nd active connection wiring layer 24v may be electrically connected to the fourth additional via electrode structure 20h and the fifth additional via electrode structure 20i through the 24th and 26th active contacts CA24 and CA26, respectively. The 22nd active connection wiring layer 24v may be electrically connected to the seventh additional via electrode structure 20k through the 25th active contact CA25. The fourth and fifth additional via electrode structures 20h and 20i may be electrically connected to the fourth and fifth active wiring lines Mx4 and Mx5 through the 23rd and 24th active connection via layers v13 and v14, respectively.

The integrated circuit device IC7-2 as described above may form guard ring structures 7G1-2 and 7G2-2 when forming the via capacitor 8C. Accordingly, manufacturing process in the integrated circuit device IC7-2 according to some embodiments may simplify and the degree of freedom in designing the integrated circuit device IC7-2 may increase by reducing the area of the via capacitor 8C and the guard ring structures 7G1-2 and 7G2-2.

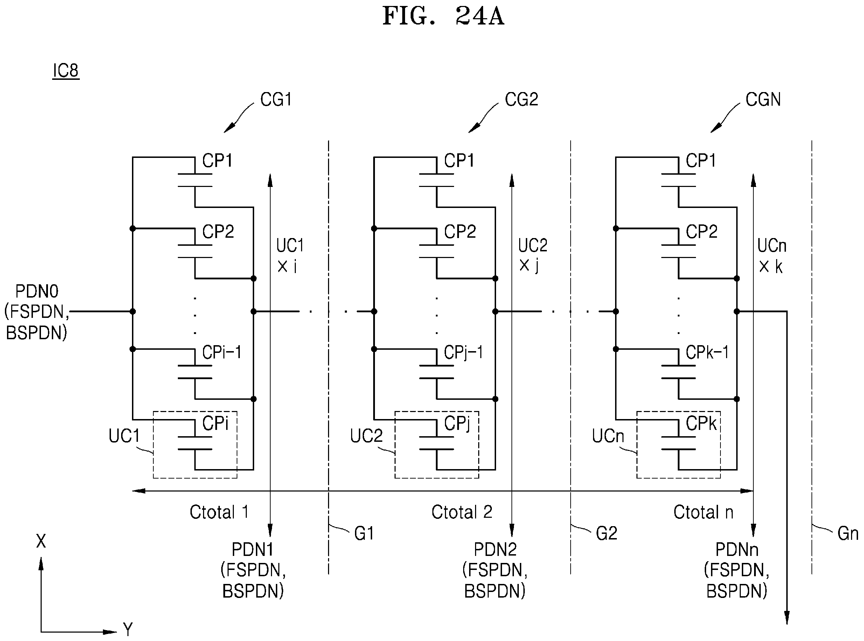

FIG. 24A is a schematic circuit diagram of an integrated circuit device according to some embodiments of the inventive concept.

Specifically, an integrated circuit device IC8 may include a plurality of capacitor groups CG1 to CGN (N is a positive integer). The capacitor groups CG1 to CGN (N is a positive integer) may be arranged and spaced apart from each other in the second direction (Y direction).

The first capacitor group CG1 may include a plurality of first unit capacitors UC1. The first unit capacitor UC1 may be any one of the via capacitors 1C, 2C, and 3C described above. The first unit capacitors UC1 may be arranged in the first direction (X direction), as expressed by UC1 x i (i is a positive integer).

The first unit capacitors UC1 may be electrically connected with one another in parallel in the first direction (X direction). The first unit capacitors UC1 may be arranged in such a configuration that capacitor electrodes face each other in the first direction (X direction). Each first unit capacitor UC1 in the first capacitor group CG1 may have its own capacitance CP1 to CPi (i is a positive integer). The first capacitor group CG1 may have a total capacitance Ctotal1.

The second capacitor group CG2 may include a plurality of second unit capacitors UC2. The second unit capacitor UC2 may be any one of the via capacitors 1C, 2C, and 3C described above. The second capacitors UC2 may be arranged in the first direction (X direction), as expressed by UC2 x j (j is a positive integer).

The second unit capacitors UC2 may be electrically connected with one another in parallel in the first direction (X direction). The second unit capacitors UC2 may be arranged in such a configuration that capacitor electrodes face each other in the first direction (X direction). Each second unit capacitor UC2 in the second capacitor group CG2 may have its own capacitance CP1 to CPj (j is a positive integer). The second capacitor group CG2 may have a total capacitance Ctotal2.

The Nth capacitor group CGN may include a plurality of Nth unit capacitors UCn. The Nth unit capacitor UCn may be any one of the via capacitors 1C, 2C, and 3C described above. Nth unit capacitors UCn may be arranged in the first direction (X direction), as expressed by UCn x k (k is a positive integer).

The Nth unit capacitors UCn may be electrically connected with one another in parallel in the first direction (X direction). Each Nth unit capacitor UCn in the Nth capacitor group CGN may have its own capacitance CP1 to CPk (k is a positive integer). The Nth unit capacitors UCn may be arranged in such a configuration that capacitor electrodes face each other in the first direction (X direction). The Nth capacitor group CGN may have a total capacitance Ctotaln.

First ends of the first capacitor group CG1 may be electrically connected to the power delivery network layers PDN0 and second ends opposite to the first ends of the first capacitor group CG1 may be electrically connected to the power delivery network layers PDN1. First ends of the second capacitor group CG2 may be electrically connected to the power delivery network layers PDN1 and second ends opposite to the first ends of the second capacitor group CG2 may be electrically connected to the power delivery network layers PDN2. Subsequently, second ends of the Nth capacitor group CGN may be electrically connected to the power delivery network layer PDNn. The power delivery network layers PDNO, PDN1, PDN2 ... PDNn may be electrically connected to one of the front side power delivery network layer FSPDN and the back side power delivery network layer BSPDN.

The front side power delivery network layer FSPDN may be arranged on a front surface (or an upper surface, e.g., first surface12a) of the dielectric layer (e.g., the dielectric layer 12) or the substrate. The back side power delivery network layer BSPDN may be arranged on the back side (or the lower side, e.g., second surface 12b) of the dielectric layer (e.g., the dielectric layer 12) or the substrate. In some embodiments, first to nth guard ring structures G1 to Gn (n is a positive integer) may be positioned in the first direction (X direction) between the capacitor groups CG1 to CGN (N is a positive integer).

Accordingly, the integrated circuit device IC8 may easily control the capacitance by arranging the capacitor groups CG1 to CGN (N is a positive integer) in the second direction (Y direction). In addition, the integrated circuit device IC8 may protect internal circuits such as transistors or active regions by placing first to nth guard ring structures G1 to Gn (n is a positive integer) in the first direction (X direction) between the capacitor groups CG1 to CGN (N is a positive integer).

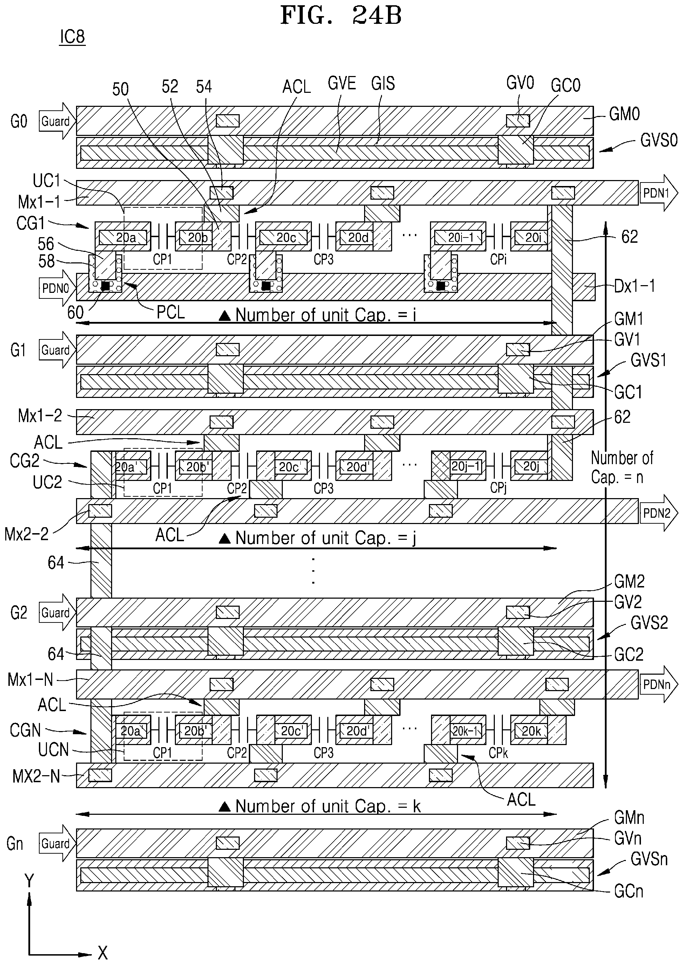

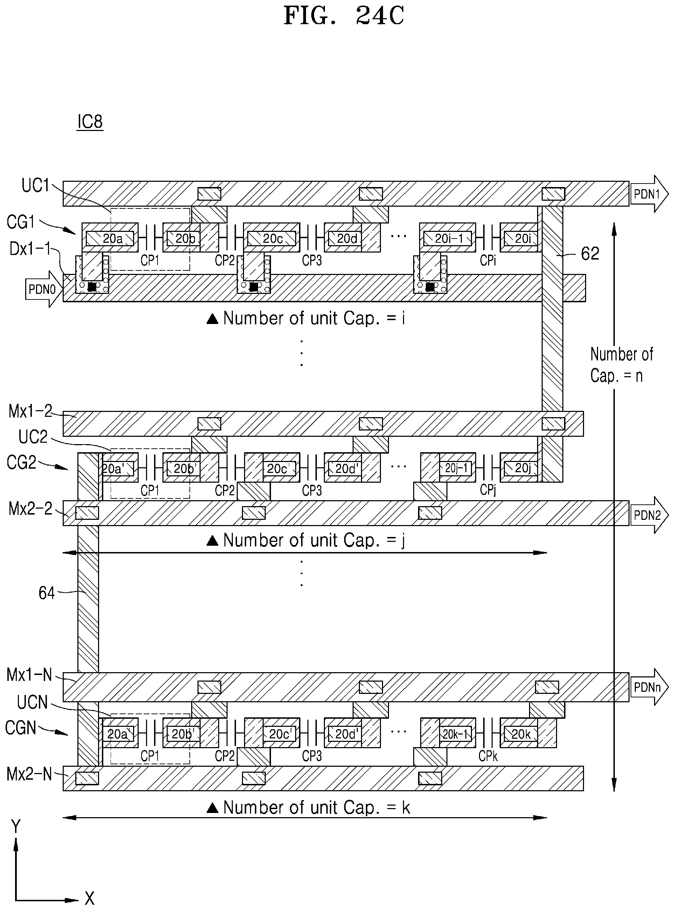

FIGS. 24B and 24C are layouts of an integrated circuit device including a via capacitor according to an embodiment.

Specifically, FIGS. 24B and 24C illustrate implemented examples of the integrated circuit device IC8 shown in FIG. 24A. Thus, the integrated circuit device IC8 shown in FIG. 24A is not limited to the implemented examples shown in FIGS. 24B and 24C. The integrated circuit device IC8 in FIG. 24C may have substantially the same structures as the integrated circuit device IC8 in FIG. 24B, except that no guard ring structures GO to Gn are provided.

An integrated circuit device IC8 according to some embodiments may include capacitor groups CG1 to CGN (N is a positive integer). The capacitor groups CG1 to CGN (N is a positive integer) may be spaced apart from each other in the second direction (Y direction).

The first capacitor group CG1 may include a plurality of first unit capacitors UC1. The first capacitor group CG1 may include a plurality of via electrode structures 20a to 20i (i is a positive integer) that are spaced apart from each other in the first direction (X direction). Each first unit capacitor UC1 in the first capacitor group CG1 may have its own capacitance CP1 to CPi (i is a positive integer).

First ends of the first capacitor group CG1 may be electrically connected to the power delivery network layer PDN0. In some embodiments, the power delivery network layer PDN0 may be a back side power delivery network layer BSPDN. The power delivery network layer PDN0 may be electrically connected to a pad wiring line Dx1-1 through a pad connection line PCL. The pad connection line PCL may include a conductive pad 56, a pad connection wiring layer 58, and a pad connection via layer 60.

Second ends opposite to the first ends of the first capacitor group CG1 may be electrically connected to the power delivery network layer PDN1. In some embodiments, the power delivery network layer PDN1 may be a front side power delivery network layer FSPDN. The power delivery network layer PDN1 may be electrically connected to an active wiring line Mx1-1 through an active connection line ACL. The active connection line ACL may include an active contact 50, an active connection wiring layer 52, and an active connection via layer 54.

As shown in FIG. 24B, a guard ring structure GO may be positioned over the first capacitor group CG1. The guard ring structure GO may include a guard ring via electrode structure GVSO. The guard ring structure GO may include a guard ring via electrode structure GVE and a guard ring via insulating layer GIS. The guard ring structure GO may include a guard wiring layer GM0 electrically connected to the guard ring via electrode structure GVS0 through a guard connection layer GC0 and a guard via GV0.

The second capacitor group CG2 may include a plurality of second unit capacitors UC2. The second capacitor group CG2 may include a plurality of via electrode structures 20a' to 20j (j is a positive integer) that are spaced apart from each other in the first direction (X direction). Each second unit capacitor UC2 in the second capacitor group CG2 may have its own capacitance CP1 to CPj (j is a positive integer).

First ends of the second capacitor group CG2 may be electrically connected to an active wiring line Mx1-2 through the active connection line ACL. The active wiring line Mx1-2 may be electrically connected to the power delivery network layer PDN1 through the connection wiring layer 62.

Second ends opposite to the first ends of the second capacitor group CG2 may be electrically connected to an active wiring line Mx2-2 through the active connection line ACL. The active wiring line Mx2-2 may be electrically connected to the power delivery network layer PDN2. In some embodiments, the power delivery network layer PDN2 may be a front side power delivery network layer FSPDN.

As shown in FIG. 24B, a guard ring structure G1 may be positioned between the first capacitor group CG1 and the second capacitor group CG2. The guard ring structure G1 may include a guard ring via electrode structure GVS1. The guard ring structure G1 may include a guard wiring layer GM1 electrically connected to the guard ring via electrode structure GVS1 through a guard connection layer GC1 and a guard via GV1.

The Nth capacitor group CGN (N is a positive integer) may include a plurality of Nth unit capacitors UCN. The Nth capacitor group CGN may include a plurality of via electrode structures 20a' to 20k (k is a positive integer) that are spaced apart from each other in the first direction (X direction). Each Nth unit capacitor UCN in the Nth capacitor group CGN may have its own capacitance CP1 to CPk (k is a positive integer).

First ends of the Nth capacitor group CGN may be electrically connected to an active wiring line Mx2-N through the active connection line ACL. The active wiring line Mx2-N may be electrically connected to the power delivery network layer PDN2 through a connection wiring layer 64.

Second ends opposite to the first ends of the Nth capacitor group CGN may be electrically connected to the power delivery network layer PDNn through the active wiring line Mx1-N and the active connection line ACL. In some embodiments, the power delivery network layer PDNn may be a front side power delivery network layer FSPDN.

As shown in FIG. 24B, a guard ring structure G2 may be positioned between the second capacitor group CG2 and the Nth capacitor group CGN. The guard ring structure G2 may include a guard ring via electrode structure GVS2. The guard ring structure G2 may include a guard wiring layer GM2 electrically connected to the guard ring via electrode structure GVS2 through a guard connection layer GC2 and a guard via GV2.

In addition, as shown in FIG. 24B, a guard ring structure Gn may be positioned under the Nth capacitor group CGN. The guard ring structure Gn may include a guard ring via electrode structure GVSn. The guard ring structure Gn may include a guard wiring layer GMn electrically connected to the guard ring via electrode structure GVSn through a guard connection layer GCn and a guard via GVn.

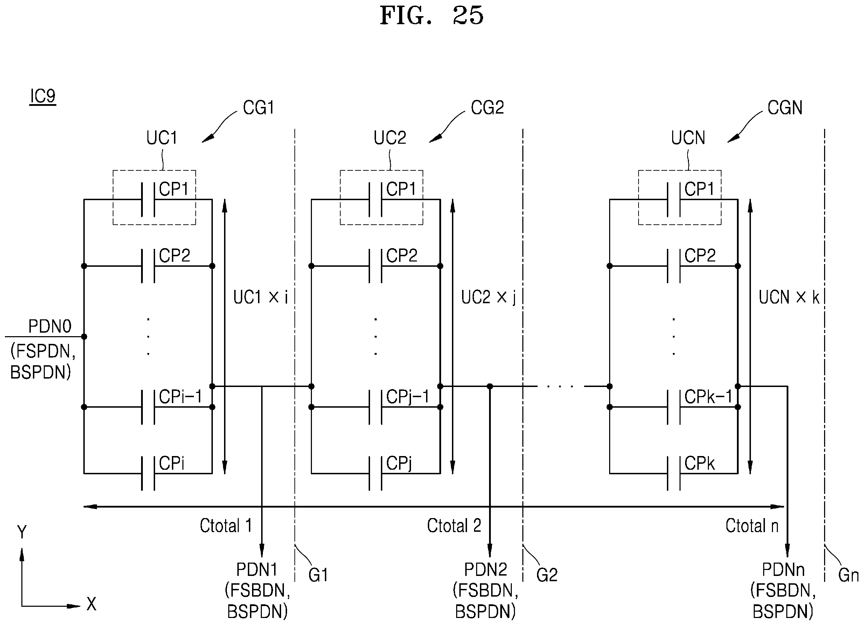

FIG. 25 is a schematic circuit diagram of an integrated circuit device according to some embodiments of the inventive concept.

Specifically, an integrated circuit device IC9 in FIG. 25 may have substantially the same structures as the integrated circuit device IC8 shown in FIG. 24a, except that the capacitor groups CG1 to CGN (N is a positive integer) are separated individually in the first direction (X direction).

The first capacitor group CG1 may include a plurality of first unit capacitors UC1. The first unit capacitor UC1 may be any one of the via capacitors 1C, 2C, and 3C described above. I first unit capacitors UC1 (I is a positive integer) may be arranged in the second direction (Y direction), as expressed by UC1 x I.

The first unit capacitors UC1 may be electrically connected with one another in parallel in the second direction (Y direction). The first unit capacitors UC1 may be arranged in such a configuration that capacitor electrodes face each other in the first direction (X direction). Each first unit capacitor UC1 in the first capacitor group CG1 may have its own capacitance CP1 to CPi (i is a positive integer). The first capacitor group CG1 may have a total capacitance Ctotal1.

The second capacitor group CG2 may include a plurality of second unit capacitors UC2. The second unit capacitor UC2 may be any one of the via capacitors 1C, 2C, and 3C described above. J second unit capacitor UC2 (J is a positive integer) may be arranged in the second direction (Y direction), as expressed by UC2 x J.

The second unit capacitors UC2 may be electrically connected with one another in parallel in the second direction (Y direction). The second unit capacitors UC2 may be arranged in such a configuration that capacitor electrodes face each other in the first direction (X direction). Each second unit capacitor UC2 in the second capacitor group CG2 may have its own capacitance CP1 to CPj (j is a positive integer). The second capacitor group CG2 may have a total capacitance Ctotal2.

The Nth capacitor group CGN may include a plurality of Nth unit capacitors UCN. The Nth unit capacitor UCN may be any one of the via capacitors 1C, 2C, and 3C described above. K Nth unit capacitors UCN (K is a positive integer) may be arranged in the second direction (Y direction), as expressed by UCN x K.

The Nth unit capacitors UCN may be electrically connected with one another in parallel in the second direction (Y direction). The Nth unit capacitors UCN may be arranged in such a configuration that capacitor electrodes face each other in the first direction (X direction). Each Nth unit capacitor UCN in the Nth capacitor group CGN may have its own capacitance CP1 to CPk (k is a positive integer). The Nth capacitor group CGN may have a total capacitance Ctotaln.

First ends of the first capacitor group CG1 may be electrically connected to the power delivery network layers PDN0 and second ends opposite to the first ends of the first capacitor group CG1 may be electrically connected to the power delivery network layers PDN1. First ends of the second capacitor group CG2 may be electrically connected to the power delivery network layers PDN1 and second ends opposite to the first ends of the second capacitor group CG2 may be electrically connected to the power delivery network layers PDN2. Subsequently, second ends of the Nth capacitor group CGN may be electrically connected to the power delivery network layer PDNn. The power delivery network layers PDNO, PDN1, PDN2 ... PDNn may be electrically connected to one of the front side power delivery network layer FSPDN and the back side power delivery network layer BSPDN.

The front side power delivery network layer FSPDN may be arranged on a front surface (or an upper surface, e.g., first surface 12a) of the dielectric layer (e.g., dielectric layer 12) or the substrate. The back side power delivery network layer BSPDN may be arranged on the back side (or the lower side, e.g., second surface 12b) of the dielectric layer (e.g., dielectric layer 12) or the substrate. In some embodiments, first to nth guard ring structures G1 to Gn (n is a positive integer) may be positioned in the second direction (Y direction) between the capacitor groups CG1 to CGN (N is a positive integer).

Accordingly, the integrated circuit device IC9 may easily control the capacitance by arranging the capacitor groups CG1 to CGN (N is a positive integer) in the first direction (X direction). In the integrated circuit device IC9, the first to nth guard ring structures G1 to Gn (n is a positive integer) may be positioned in the second direction (Y direction) between the capacitor groups CG1 to CGN (N is a positive integer).

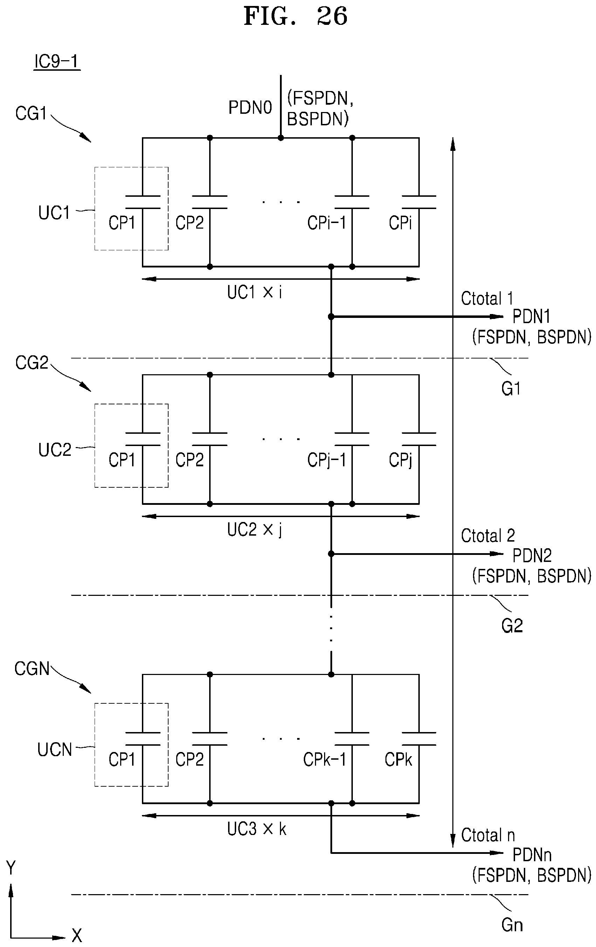

FIG. 26 is a schematic circuit diagram of an integrated circuit device according to some embodiments of the inventive concept.

Specifically, an integrated circuit device IC9-1 in FIG. 26 may have substantially the same structures as the integrated circuit device IC9 in FIG. 25, except that the first to Nth capacitor groups CG1 to CGN (N is a positive integer) are separated individually in the second direction (Y direction) and the arrangement direction of the capacitor electrodes is changed.

The first capacitor group CG1 may include a plurality of first unit capacitors UC1. The first unit capacitor UC1 may be any one of the via capacitors 1C, 2C, and 3C described above. I first unit capacitors UC1 (I is a positive integer) may be arranged in the first direction (X direction), as expressed by UC1 x I.

The first unit capacitors UC1 may be electrically connected with one another in parallel in the first direction (X direction). The first unit capacitors UC1 may be arranged in such a configuration that capacitor electrodes face each other in the second direction (Y direction). Each first unit capacitor UC1 in the first capacitor group CG1 may have its own capacitance CP1 to CPi (i is a positive integer). The first capacitor group CG1 may have a total capacitance Ctotal1.

The second capacitor group CG2 may include a plurality of second unit capacitors UC2. The second unit capacitor UC2 may be any one of the via capacitors 1C, 2C, and 3C described above. J second capacitors UC2 (J is a positive integer) may be arranged in the first direction (X direction), as expressed by UC2 x J.

The second unit capacitors UC2 may be electrically connected with one another in parallel in the first direction (X direction). The second unit capacitors UC2 may be arranged in such a configuration that capacitor electrodes face each other in the second direction (Y direction). Each second unit capacitor UC2 in the second capacitor group CG2 may have its own capacitance CP1 to CPj (j is a positive integer). The second capacitor group CG2 may have a total capacitance Ctotal2.

The Nth capacitor group CGN may include a plurality of Nth unit capacitors UCN. The Nth unit capacitor UCN may be any one of the via capacitors 1C, 2C, and 3C described above. K Nth unit capacitors UCN (K is a positive integer) may be arranged in the first direction (X direction), as expressed by UCN x K.

The Nth unit capacitors UCN may be electrically connected with one another in parallel in second first direction (Y direction). The Nth unit capacitors UCN may be arranged in such a configuration that capacitor electrodes face each other in the first direction (X direction). Each Nth unit capacitor UC2 in the Nth capacitor group CGN may have its own capacitance CP1 to CPk (k is a positive integer). The Nth capacitor group CGN may have a total capacitance Ctotaln.

First ends PDN0 and second ends PDN1 of the first capacitor group CG1 may be electrically connected to either the front side power delivery network layer FSPDN or the back side power delivery network layer BSPDN.

First ends PDN1 and second ends PDN2 of the second capacitor group CG2 may be electrically connected to either the front side power delivery network layer FSPDN or the back side power delivery network layer BSPDN. First ends PDN2 and second ends PDNn of the Nth capacitor group CGN may be electrically connected to either the front side power delivery network layer FSPDN or the back side power delivery network layer BSPDN.

The front power delivery network layer FSPDN may be arranged on a front side (or an upper side, e.g., first surface 12a) of the dielectric layer (e.g., dielectric layer 12) or the substrate. The back side power delivery network layer BSPDN may be arranged on a rear side (or the lower/back side, e.g., second surface 12b) of the dielectric layer (e.g., dielectric layer 12) or the substrate. Accordingly, the integrated circuit device IC9-1 may easily control the capacitance by arranging the capacitor groups CG1 to CGN (N is a positive integer) in the second direction (Y direction). In the integrated circuit device IC9-1, first to nth guard ring structures G1 to Gn (n is a positive integer) may be positioned in the first direction (X direction) between the capacitor groups CG1 to CGN (N is a positive integer).

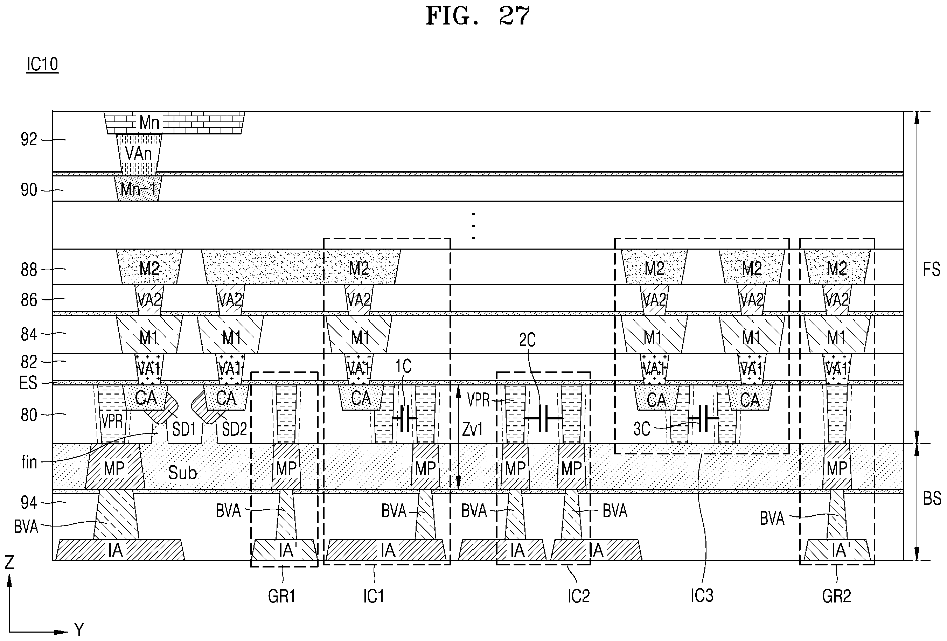

FIG. 27 is a cross-sectional view of an integrated circuit device according to some embodiments of the inventive concept.

Specifically, an integrated circuit device IC10 in FIG. 27 may be a cross-sectional view illustrating an implemented example embodiment of the integrated circuit devices IC1 to IC9 described above. The integrated circuit device IC10 may include a front side portion FS and a back side portion BS. The front side portion FS and the back side portion BS may be determined based on a single surface of the substrate Sub.

In an embodiment, the substrate Sub may be a semiconductor substrate. For example, the substrate Sub may include a semiconductor material such as silicon (Si) or germanium (Ge), but embodiments are not limited thereto. In another embodiment, the substrate Sub may include an insulating layer. For example, the substrate Sub may include a silicon oxide layer, a silicon nitride layer, a silicon carbide layer, silicon oxycarbide layer, a silicon oxynitride layer, and/or a silicon oxycarbonitride layer, but embodiments are not limited thereto. The substrate Sub may correspond to the first passivation layer 38a in the aforementioned embodiments.

A plurality of penetrating structures VPR may be arranged in the front side portion FS such that the penetrating structures VPR are spaced apart inside a middle layer 80. One of more of the penetrating structures VPR may be via power rails that supply power to the source/drain of a transistor in an active region where the transistor is arranged. The one or more via power rails may electrically connect the back side power delivery network layer BSPDN, which is arranged on the back side of the substrate Sub, with one or more corresponding source/drain contacts.

In contrast, the others of the penetrating structures VPR may be the via electrode structures 20a to 20d described above in an inactive region where the via capacitors 1C, 2C, and 3C are arranged. The penetrating structures VPR may include the same or similar structures and materials.

For example, the penetrating structures VPR may have the same structures and materials as the via electrode structures 20a to 20d described above or be similar thereto. The via power rail and the via electrode structures 20a to 20d may overlap with each other in a first direction (X direction) or a second direction (Y direction). For example, the via power rail and the via electrode structures 20a to 20d may be at the same level (e.g., at the same distance from the substrate Sub) in the third direction (Z direction).

The middle layer 80 may correspond to the dielectric layer 12 in the aforementioned embodiments. In some embodiments, the middle layer 80 may include a device isolating layer, which is arranged between fin-type active regions in the active region where the transistor is arranged, and an interlayer insulating layer on the device isolating layer.

In some embodiments, the middle layer 80 may include a material different from the active region between the via electrode structures (e.g., via electrode structures 20a to 20d). In some embodiments, the middle layer 80 between the via electrode structures may have the same material as the middle layer 80 in the active region.

In some embodiments, as described above, the middle layer 80 may include a semiconductor material, such as silicon (Si) and germanium (Ge), between the via electrode structures, but not limited thereto. In some embodiments, the middle layer 80 may include an insulating layer, for example, a silicon oxide layer, a silicon nitride layer, a silicon carbide layer, a silicon oxycarbide layer, a silicon oxynitride layer, and/or a silicon oxycarbonitride layer, but embodiments are not limited thereto.

A first via VA1, a first wiring layer M1, a second via VA2, and a second wiring layer M2 may be electrically connected to the via electrode structures VPR through an active contact CA in the front side portion FS of the integrated circuit device IC10. For example, the via electrode structures VPR correspond to the via electrode structures 20a to 20d in the FIG. 2A. The first via VA1, the first wiring layer M1, the second via VA2, and the second wiring layer M2 may be insulated from each other by interlayer insulating layers 82, 84, 86, and 88. The first via VA1, the first wiring layer M1, the second via VA2, and the second wiring layer M2 that are electrically connected with one another through the active contact CA may be provided as the front side power delivery network layer.

Source area SD1 and drain area SD2 may be provided at the surface portions of the substrate Sub corresponding to the fin-type active region in the front side portion FS. The source area SD1 and the drain area SD2 may be electrically connected to the first via VA1, the first wiring layer M1, the second via VA2, and the second wiring layer M2 through the active contact CA. In FIG. 27, gate patterns of the transistor are not shown due to the cutting direction of the cross-sectional view. Accordingly, the transistor may be arranged on the front side portion FS. Wiring layers Mn-1 and Mn, a via VAn, and interlayer insulating layers 90 and 92 may be arranged upwards on the second wiring layer M2 and the interlayer insulating layer 88. In FIG. 27, reference mark ES designates an etch stop layer.

A back side via BVA and a back side wiring layer IA may be electrically connected to the via electrode structures VPR through a conductive pad MP in the back side portion BS of the integrated circuit device IC10. The back side via BVA may be insulated from the surroundings by a back side interlayer insulating layer 94. The back side via BVA and the back side wiring layer IA, which are electrically connected with each other by the conductive pad MP, may be provided as the back side power delivery network layer. A particular back side wiring layer IA' among the back side wiring layer IA may be electrically floated.

In an embodiment, the integrated circuit device IC10 may be implemented to include the integrated circuit devices IC1 to IC3, as shown in FIG. 27. In addition, the integrated circuit device IC10 may include guard ring structures GR1 and GR2 including the floated back side wiring layer IA'.

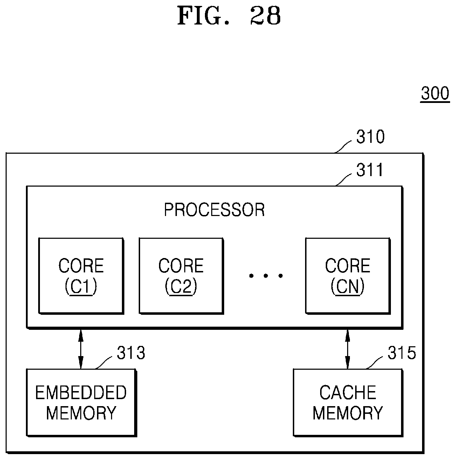

FIG. 28 is a block diagram showing a configuration of an electronic device including an integrated circuit device according to some embodiments of the inventive concept.

Specifically, the electronic device 300 may include a system-on-chip 310. The system-on-chip 310 may include a processor 311, an embedded memory 313, and a cache memory 315. The processor 311 may include one or more processor cores C1-CN. The processor cores C1-CN may process data and signals. The processor cores C1-CN may include the integrated circuit devices IC1 to IC8 according to embodiments.

The electronic device 300 may perform unique functions by using the processed data and signals. For example, the processor 311 may include an application processor (AP), but embodiments are not limited thereto. The embedded memory 313 may exchange first data DAT1 with the processor 311. The first data DAT1 may include various data processed or to be processed by the processor cores C1-CN. The embedded memory 313 may manage the first data DAT1. For example, the embedded memory 313 may temporarily store or buffer the first data DAT1. The embedded memory 313 may function as a buffer memory or a working memory for the processor 311.

The embedded memory 313 may include a static random access memory (SRAM), but embodiments are not limited thereto. The SRAM may operate at a speed greater than a dynamic random access memory (DRAM). When the SRAM is embedded in the system-on-chip 310, the electronic device 300 may be implemented in a smaller size and operate at a higher speed. Furthermore, when the SRAM is embedded in the system-on-chip 310, the active power consumption of the electronic device 300 may decrease.

For example, the SRAM may include the integrated circuit device IC1 to IC9-1 according to embodiments. The cache memory 315 may be mounted on the system-on-chip 310 with the processor cores C1 to CN. The cache memory 315 may store cache data DATc. The cache data DATc may be data used by the processor cores C1 to CN. The cache memory 315 may have a small storage capacity but may operate at a very high speed.

For example, the cache memory 315 may include the SRAM including the integrated circuit device IC1 to IC9-1 according to embodiments. When the cache memory 315 is used in the electronic device 300, the access number and the access time of the processor 311 to the embedded memory 313 may be reduced. Accordingly, when the cache memory 315 is used, the operation speed of the electronic device 300 may be increased. In FIG. 28, the cache memory 315 is shown as an individual component separated from the processor 311 for better understanding. However, the cache memory 315 may be configured to be included in the processor 311.

It will be understood that, although the terms "first", "second", "third", and so on may be used herein to illustrate various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

In addition, it will also be understood that when a first element or layer is referred to as being present "on" or "beneath" a second element or layer, the first element may be disposed directly on or beneath the second element or may be disposed indirectly on or beneath the second element with a third element or layer being disposed between the first and second elements or layers. It will be understood that when an element or layer is referred to as being "connected to", or "coupled to" another element or layer, it may be directly on, connected to, or coupled to the other element or layer, or one or more intervening elements or layers may be present. In contrast, when an element is referred to as being "directly coupled," "directly connected," or "directly responsive" to, or "directly on," another element, there are no intervening elements present. In addition, "electrical connection" conceptually includes a physical connection and a physical disconnection. In addition, it will also be understood that when an element or layer is referred to as being "between" two elements or layers, it may be the only element or layer between the two elements or layers, or one or more intervening elements or layers may also be present.

Further, as used herein, when a layer, film, region, plate, or the like may be disposed "on" or "on a top" of another layer, film, region, plate, or the like, the former may directly contact the latter or still another layer, film, region, plate, or the like may be disposed between the former and the latter. As used herein, when a layer, film, region, plate, or the like is disposed "directly on" or "directly on a top" of another layer, film, region, plate, or the like, the former directly contacts the latter and still another layer, film, region, plate, or the like is not disposed between the former and the latter. Further, as used herein, when a layer, film, region, plate, or the like may be disposed "below" or "under" another layer, film, region, plate, or the like, the former may directly contact the latter or still another layer, film, region, plate, or the like may be disposed between the former and the latter. As used herein, when a layer, film, region, plate, or the like is disposed "directly below" or "directly under" another layer, film, region, plate, or the like, the former directly contacts the latter and still another layer, film, region, plate, or the like is not disposed between the former and the latter.

Spatially relative terms, such as "beneath," "below," "lower," "under," "above," "upper," and the like, may be used herein for ease of explanation to illustrate one element or feature's relationship to another element or feature as illustrated in the figures. It will be understood that the spatially relative terms are intended to encompass different orientations of the device in use or in operation, in addition to the orientation depicted in the figures. For example, when the device in the drawings may be turned over, elements described as "below" or "beneath" or "under" other elements or features would then be oriented "above" the other elements or features. Thus, the example terms "below" and "under" may encompass both an orientation of above and below. The device may be otherwise oriented, for example, rotated 90 degrees or at other orientations, and the spatially relative descriptors used herein should be interpreted accordingly.

A shape, a size, a ratio, an angle, a number, etc. disclosed in the drawings for illustrating embodiments of the present disclosure are illustrative, and the present disclosure is not limited thereto. The same reference numerals may refer to the same elements herein. Further, descriptions and details of well-known steps and elements may be omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits may not be described in detail so as not to unnecessarily obscure aspects of the present disclosure.

Although the inventive concept has been described above with reference to the embodiments illustrated in the drawings, this is merely an example, and those of ordinary skill in the art will understand that various modifications, substitutions, and equal other embodiments are possible therefrom. It should be understood that the embodiments described above are examples in all aspects and are not limited. The true technical protection scope of the inventive concept should be determined by the technical idea of the appended patent claims.

While the inventive concept has been particularly shown and described with reference to embodiments thereof, it will be understood that various changes in form and details may be made therein without departing from the scope of the following claims.

## Claims

1. An integrated circuit device comprising:
a dielectric layer;
a first power delivery network layer on a first surface of the dielectric layer;
a second power delivery network layer on a second surface of the dielectric layer, wherein the second surface of the dielectric layer is opposite to the first surface of the dielectric layer in a vertical direction; and
a via capacitor between the first surface and the second surface of the dielectric layer,
wherein the via capacitor includes:
a first via electrode structure and a second via electrode structure that are spaced apart from each other in one of a first horizontal direction and a second horizontal direction that intersects with the first horizontal direction; and
a first end portion and a second end portion that is opposite to the first end portion of the via capacitor, wherein the first end portion and the second end portion are electrically connected to the first power delivery network layer and the second power delivery network layer, respectively.

2. The integrated circuit device of claim 1, wherein the first via electrode structure includes a first via electrode between the first surface and the second surface of the dielectric layer and a first via insulating layer on opposing sidewalls of the first via electrode, and
wherein the second via electrode structure includes a second via electrode between the first surface and the second surface of the dielectric layer and a second via insulating layer on opposing sidewalls of the second via electrode.

3. The integrated circuit device of claim 1 or claim 2, wherein at least one of the first power delivery network layer and the second power delivery network layer includes a first active connection line that is electrically connected to one of the first via electrode structure and the second via electrode structure and a first active wiring line that is electrically connected to the first active connection line.

4. The integrated circuit device of claim 3, wherein the first active wiring line extends in the first horizontal direction on one of the first surface and the second surface of the dielectric layer, and the first active connection line extends in the second horizontal direction on the one of the first surface and the second surface of the dielectric layer.

5. The integrated circuit device of any preceding claim, wherein at least one of the first power delivery network layer and the second power delivery network layer includes a first pad connection line that is electrically connected to one of the first via electrode structure and the second via electrode structure and a first pad wiring line that is electrically connected to the first pad connection line.

6. The integrated circuit device of claim 5, wherein the first pad wiring line extends in the first horizontal direction on one of the first surface and the second surface of the dielectric layer, and the first pad connection line extends in the second horizontal direction on the one of the first surface and the second surface of the dielectric layer.

7. The integrated circuit device of any preceding claim, wherein:
the via capacitor is one of a plurality of via capacitors between the first surface and the second surface of the dielectric layer,
wherein the plurality of via capacitors include a plurality of via electrode structures that are spaced apart from each other in one of a first horizontal direction and a second horizontal direction that intersects with the first horizontal direction,
wherein first end portions of the plurality of via capacitors are electrically connected to the first power delivery network layer, and
wherein second end portions opposite to the first end portions of the plurality of via capacitors in the vertical direction are electrically connected to the second power delivery network layer.

8. The integrated circuit device of claim 7, wherein each of the plurality of via electrode structures includes a via electrode between the first surface and the second surface of the dielectric layer and a via insulating layer on opposing sidewalls of the via electrode.

9. The integrated circuit device of claim 7 or claim 8, wherein at least one of the first power delivery network layer and the second power delivery network layer includes a first active connection line electrically connected to one of the plurality of via electrode structures and a first active wiring line electrically connected to the first active connection line.

10. The integrated circuit device of claim 9, wherein at least one of the first power delivery network layer and the second power delivery network layer includes a first additional active connection line electrically connected to one of the plurality of via electrode structures and a first additional active wiring line electrically connected to the first additional active connection line.

11. The integrated circuit device of any of claims 7-10, wherein at least one of the first power delivery network layer and the second power delivery network layer includes a first pad connection line that is electrically connected to one of the plurality of via electrode structures and a first pad wiring line electrically connected to the first pad connection line.

12. The integrated circuit device of claim 11, wherein at least one of the first power delivery network layer and the second power delivery network layer includes a first additional pad connection line that is electrically connected to one of the plurality of via electrode structures and a first additional pad wiring line electrically connected to the first additional pad connection line.

13. The integrated circuit device of any of claims 7-12, further comprising a plurality of guard ring structures spaced apart from one of the first power delivery network layer and the second power delivery network layer, wherein the plurality of guard ring structures include additional via electrode structures between the first surface and second surface of the dielectric layer.

14. The integrated circuit device of claim 13, wherein each of the plurality of via electrode structures include a via electrode between the first surface and the second surface of the dielectric layer and a via insulating layer on opposing sidewalls of the via electrode.

15. The integrated circuit device of claim 13 or claim 14, wherein the plurality of guard ring structures extend around the plurality of via electrode structures in a plan view.
